# EUROPÄISCHE PATENTSCHRIFT

(11) **EP 0 573 791 B1**
(45) Veröffentlichungstag und Bekanntmachung des Hinweises auf die Patenterteilung: **19.03.1997**
(21) Anmeldenummer: 93107493.4
(22) Anmeldetag: 08.05.1993
(51) Int. Cl.: H05K 13/06, H01R 43/28

(54) **Verfahren zum Verdrahten von Anschlussstellen elektrischer Geräte oder Baugruppenelemente**
Wiring method of connection places of electrical devices or of elements of electrical units
Méthode de câblage de places de raccordement des appareils électriques ou des éléments d'unités électriques

(30) Priorität: 06.06.1992 DE 4218741
(43) Veröffentlichungstag der Anmeldung: 15.12.1993
(73) Patentinhaber: Vossloh Schwabe GmbH, D-73660 Urbach (DE)
(72) Erfinder: Emmerich, Herbert, W-7050 Waiblingen-Neustadt (DE); Koller, Stefan, W-7908 Niederstotzingen (DE); Albeck, Bernhard, W-7073 Lorch-Waldhausen (DE); Mews, Hans-Peter, W-5880 Lüdenscheid (DE)
(74) Vertreter: Patentanwälte Rüger, Barthelt & Abel

(56) Entgegenhaltungen:
- DE-A- 3 608 243
- DE-B- 1 290 210
- US-A- 3 930 524
- US-A- 4 129 349

## Beschreibung

Die Erfindung betrifft ein Verfahren zum Verdrahten von Anschlußstellen elektrischer Geräte oder Baugruppenelemente mit Hilfe von gesteuerten mechanischen Leitungsverlegemitteln, insbesondere zur Durchführung dieses Verfahrens eingerichtete Leitungsverlegemittel und eine zur Verwendung bei diesem Verfahren ausgebildete Anschlußstelle.

Unter "Verdrahten" versteht man in der Praxis bei elektrischen Geräten oder Baugruppenelementen das Verbinden von Anschlußstellen mit einer elektrischen Leitung, sowie das Kontaktieren dieser Leitung an der jeweiligen Anschlußstelle, um damit eine elektrische Verbindung, bspw. mit dem zugeordneten Schaltelement, herzustellen. Eine solche Verdrahtung ist bei der Mehrzahl der im Niederstrombereich arbeitenden elektrischen Geräte, einschließlich elektronischer Schaltsteuer- und Regelgeräte, sowie bei Baugruppenelementen erforderlich, wobei von diesem Sammelbegriff insbesondere auch Elemente wie Leiterplatten, Einschübe etc. verstanden sind, die handelsüblich als Einheiten aufgebaut und dazu bestimmt sind, in elektrische Geräte eingesetzt zu werden. Zur Verdrahtung selbst werden als Leitungen in der Regel Schaltdrähte, die mit einem Lacküberzug oder einer Isoliermaterialumhüllung versehen sind, oder aber isolierte Litzen verwendet.Der Anschluß der endseitig abisolierten Leitungen in der Kontaktierzone der jeweiligen Anschlußstelle geschieht unter Benutzung unterschiedlicher bekannter Anschlußtechniken (z.B. Schraubtechnik, Stecktechnik, Löttechnik, Schneidklemmtechnik, Crimptechnik). Dabei werden die zur Verdrahtung notwendigen Arbeitsschritte noch heute zum überwiegenden Teil manuell durchgeführt. Dies ist zeitaufwendig und erfordert häufig geschultes Personal; der entstehende Kostenaufwand ist deshalb beträchtlich.

Um zu einer rationelleren Fertigung, insbesondere bei der Herstellung größerer Serien gleicher elektrischer Geräte zu kommen, ist es bekannt, zunächst in einem ersten Bereich getrennt von dem elektrischen Gerät die Leitungen vorzukonfektionieren oder Teil- oder Komplettkabelbäume herzustellen, d.h. ein typisches Vormontageprodukt zu erzeugen. In einem zweiten Bereich erfolgt dann anschließend die Montage dieses Vormontageproduktes in das jeweilige Gerät oder Endprodukt. Diese Endmontage beinhaltet im wesentlichen das Kontaktieren oder Anschließen der einzelnen Leitungen des Vormontageproduktes in den Kontaktierzonen der Anschlußstellen, sowie das Verlegen und Sichern der vorkonfektionierten Leitungen oder Kabelbäume in dem Gerät. Während für die Vorkonfektionierung der Leitungen heute schon automatisierte Vorkonfektioniereinrichtungen im Einsatz sind, erfolgen die sich anschließende Weiterverarbeitung der konfektionierten Leitungen, etwa zur Teil- oder Komplettkabelbaumfertigung, ebenso wie die Arbeitsvorgänge direkt am Verdrahtungsplatz fast ausschließlich manuell.

Zur automatischen Herstellung von Kabelbäumen sind auch schon eine Reihe von Verfahren und Vorrichtungen bekannt geworden (US -A- 4677 734, DE-A1 36 08 243, 36 11 805, 38 20 636, 38 20 638, CH-C- 598 740), die durchweg mit sogenannten Verlegebrettern und dergl. arbeiten. Diese Verfahren bedingen aber durchweg einen sehr hohen technischen Aufwand, der nur für größere Geräteserien infrage kommen kann. Auf jeden Fall verbleibt aber bei dieser Technik die grundsätzliche Problematik, daß die Endmontage der vorkonfektionierten Leitungen oder Kabelbäume mit einem erheblichen Arbeitsaufwand verbunden ist, so daß der erzielbare Rationalisierungseffekt beschränkt bleibt. Außerdem ist die Leitungsführung in dem Gerät häufig mit Rücksicht auf die Vorkonfektionierung der Leitungen oder Kabelbäume zu wählen, was lange Verlegewege mit Umlenkungen, Abzweigungen, Schleifen, sowie Doppelbewegungen von Klemmeinrichtungen mit sich bringt.

Daneben ist es auch, bekannt vormontierte Gerätekomponenten unmittelbar zu verdrahten, d.h. ohne Verwendung vorkonfektionierter Verdrahtungen oder Kabelbäume. Bei einem aus der US-A 4129349 bekannten Verfahren zur Verlegung von elektrischen Leitungen in einem Brettschaltungsaufbau sind die Anschlußelemente als Schneidklemmen ausgebildet. Die fortlaufend von einer Vorratsrolle abgezogene Leitung wird mittels eines handgeführten Leitungsverlegewerkzeugs an den Anschlußstellen aufeinanderfolgend jeweils in eine Schneidklemme eingedrückt, um damit die Kontaktierung und Fixierung der Leitung an der Anschlußstelle zu erzielen. Am Ende des Leitungsverlegeweges wird die Leitung neben der Schneidklemme der letzten Anschlußstelle unter Verwendung eines an dem Leitungsverlegewerkzeug vorgesehenen, in Gestalt eines Schneidstempels oder einer Schneidzange ausgebildeten Schneidwerkzeuges, abgeschnitten. Irgendwelche Vorkehrungen zur berührungssicheren Isolation des Schneidklemmkontaktes oder des abgeschnittenen Leiterendes sind nicht vorgesehen. Nach dem Eindrücken der Leitung in den Schneidklemmkontakt wird das Werkzeug zum Abschneiden der Leitung in einem eigenen Arbeitsgang angehoben und umgesetzt. Das Leitungsverlegewerkzeug kann im übrigen auch in einer halb- oder vollautomatischen Verdrahtungsmaschine eingesetzt werden, bei der die einzelnen Anschlußstellen programmgesteuert in den Arbeitsbereich des gegebenenfalls von Hand geführten Leitungsverlegewerkzeugs bewegt werden.

Allgemein gesehen ist aus dieser Druckschrift ein Verfahren zum Verdrahten von Anschlußstellen elektrischer Baugruppenelemente mit Hilfe von gesteuerten mechanischen Leitungsverlegemitteln bekannt, bei dem folgende Schritte ausgführt werden:
Ein vormontiertes elektrisches Baugruppenelement wird mit fest darin angeordneten Anschlußstellen bereitgestellt, die Kontaktierzonen in Schneidklemmtechnik aufweisen,
durch eine Relativbewegung zwischen dem vormontierten Baugruppenelement und den Leitungsverlegemitteln wird eine erste Anschlußstelle in den Arbeitsbereich der Leitungsverlegemittel gebracht und relativ zu diesen lagerichtig positioniert,
mittels der Leitungsverlegemittel wird das Ende einer diesen endlos zugeführten Leitung in eine erste Anschlußstelle eingeführt und eingedrückt und an dieser Anschlußstelle fixiert,
durch jeweils eine weitere Relativbewegung längs einer vorgegebenen Bahn zwischen dem vormontierten elektrischen Baugruppenelement und den Leitungsverlegemitteln wird unter Verlegung der Leitung aufeinanderfolgend jede weitere Anschlußstelle eines Leitungszuges in den Arbeitsbereich der Leitungsverlegemittel gebracht und relativ zu diesen lagerichtig positioniert, wobei während jeder dieser Relativbewegungen die Leitungsverlegemittel zumindest eine dem Leitungsverlegungsweg zwischen den beiden jeweiligen Anschlußstellen entsprechende Länge der ihnen endlos zugeführten Leitung ausgeben, die so groß bemessen wird, daß die zwischen den Anschlußstellen verlegte Leitung im wesentlichen zugspannungsfrei ist,
mittels der Leitungsverlegemittel wird die diesen endlos zugeführte Leitung bei jeder Anschlußstelle in diese Anschlußstelle eingeführt und eingedrückt, wobei an der letzten Anschlußstelle des Leitungsverlegeweges die Leitung abgeschnitten wird.

Aufgabe der Erfindung ist es, ein Verdrahtungsverfahren für elektrische Geräte und Baugruppenelemente zu schaffen, das es erlaubt, die Verdrahtung gegenüber den bekannten Verfahren weiter zu rationalisieren, wobei gleichzeitig eine hohe Betriebssicherheit bei Reduzierung der Fehlermöglichkeiten der Verdrahtung gewährleistet ist.

Zur Lösung dieser Aufgabe weist das erfindungsgemäße Verfahren die Merkmale des Patentanspruchs 1 auf.

Das neue Verfahren gewährleistet eine rationelle vollständige Automatisierung der Verdrahtung elektrischer Geräte und Baugruppenelemente. Es erlaubt es, auf vorkonfektionierte Leitungen und Teil- oder Vollkabelbäume zu verzichten, weil es eine Direktmontage der Leitungen in dem Gerät bzw. dem Baugruppenelement vornimmt. Dabei wird die Leitung als zwischen den Anschlußstellen definiert verlegte Endlosleitung an den mit automatisierungsgerechten Kontaktierzonen in Schneidklemmentechnik versehenen Anschlußstellen vollautomatisch kontaktiert und schließlich nicht nur abgeschnitten, sondern das Leitungsende wird an der Schneidklemme gleichzeitig auch berührungssicher verwahrt. Damit entfallen alle zusätzlichen Maßnahmen zur Herstellung der Berührungssicherheit am Leitungsende.

Gleichzeitig ergibt sich im Vergleich zum Stand der Technik ein Rationalisierungseffekt auch dadurch, daß jede Anschlußstelle, einschließlich der letzten auf dem Leitungsverlegeweg nur einmal angesteuert zu werden braucht.

Die Ausbildung der Kontaktierzonen an den einzelnen Anschlußstellen ist automatisierungsgerecht indem Kontaktierzonen in Schneidklemmtechnik verwendet werden. Die Schneidklemmtechnik ergibt eine sehr hochwertige elektrische Verbindung des elektrischen Leiters der anzuschließenden Leitung mit den Kontaktmitteln, weil sie ein flächiges, gasdichtes Kontaktieren nach Art einer Kaltverschweißung bewirkt. Da der Leiter sofort nach dem Aufschneiden der Isolation kontaktiert wird, kann keine Oxidation der Leiteroberfläche auftreten, wie dies der Fall ist, wenn die Leitungsenden vor dem Kontaktieren in einem eigenen Arbeitsgang zunächst abisoliert werden. Zur Fixierung wird die Leitung beim Eindrücken zweckmäßigerweise auf wenigstens einer Seite der Schneidklemme festgeklemmt. Das Eindrücken selbst geschieht mit Vorteil derart, daß beidseitig der Kontaktierzone auf die Leitung eine Eindrückkraft ausgeübt wird, so daß die Leitung beim Eindrücken einwandfrei ausgerichtet bleibt und sicher kontaktiert sowie festgeklemmt wird.

Bei konstruktiv bedingten langen Verlegewegen kann durch eine Relativbewegung zwischen dem vormontierten Gerät oder Baugruppenelement auch eine Abstütz- oder Halterungsstelle in den Arbeitsbereich der Leitungsverlegemittel gebracht und relativ zu diesen lagerichtig positioniert werden, wobei dann mittels der Leitungsverlegemittel die Leitung in eine Halterung an der Abstütz- oder Halterungsstelle eingebracht und dort befestigt wird. Von dieser Abstütz- oder Halterungsstelle aus wird bei der neuen Direktverdrahtung die Leitung dann zu der nächstfolgenden Anschlußstelle geführt, an deren Kontaktierzone sie wieder kontaktiert und gegebenenfalls abgeschnitten wird.

Bei dem neuen Verfahren können an den entsprechenden aufeinanderfolgend angesteuerten Anschlußstellen sowohl der Leitungsanfang als auch das Leitungsende, wie auch eine durchgehende Leitung kontaktiert werden. Da der Leitungsanfang bei Beginn der Verlegung einer Leitung an der Anschlußstelle fixiert wird, kann die bei der Direktverlegung der Leitung erforderliche Zugentlastung einfach dadurch erzielt werden, daß die während einer Leitungsverlegung zwischen zwei Anschlußstellen von den Leitungsverlegemitteln abgegebene Leitungslänge mit der Relativbewegung zwischen dem vormontierten Gerät oder der Baugruppe und deren Leitungsverlegemitteln zwangssynchronisiert wird. Dabei ist die von den Leitungsverlegemitteln abgegebene Leitungslänge so groß bemessen, daß die zwischen den Anschlußstellen verlegte Leitung zugspannungsfrei ist. Falls erforderlich, kann diese Leitung auch ohne weiteres mit übergroßer Leitungslänge, bspw. durchhängend, verlegt werden.

Für die praktische Durchführung des neuen Verdrahtungsverfahrens ist es vorteilhaft, wenn mit der Relativbewegung zwischen dem vormontierten Gerät oder Bauelement und den Leitungsverlegemitteln die Leitungsverlegemittel lediglich in die Nähe der jeweiligen Anschlußstelle gesteuert und anschließend in einer Positionierbewegung genau lagerichtig zu der Anschlußstelle positioniert werden. Auf diese Weise wird erreicht, daß an die längs der dem vorgegebenen Verlegeweg entsprechenden Bahn erfolgende Verfahrbewegung der Leitungsverlegemittel keine allzugroße Genauigkeitsanforderungen gestellt werden müssen, während gleichzeitig eine exakte Vorpositionierung der Anschlußstellen selbst bzw. der diese tragenden Bauelemente in dem elektrischen Gerät oder der elektrischen Baugruppe sich erübrigt. Den in die Nähe der jeweiligen Anschlußstelle verbrachten Leitungsverlegemitteln kann die zur exakten Positionierung erforderliche Positionierbewegung im unmittelbaren Zusammenwirken zwischen einem Verlegewerkzeug der Leitungsverlegemittel und der entsprechend gestalteten Anschlußstelle oder einer an dieser vorgesehenen Führungseinrichtung erteilt werden, um eine ganz einfache Möglichkeit zu erwähnen. Es kann aber auch derart vorgegangen werden, daß bei in die Nähe der Anschlußstelle gebrachten Leitungsverlegemitteln mit Lagefühlmitteln die Lageabweichung von der Position der Anschlußstelle ermittelt und selbsttätig ausgeglichen wird. Zur Ermittlung der Lageabweichung können an sich beliebige Fühlmittel verwendet werden. Als besonders zweckmäßig hat sich dafür ein den Leitungsverlegemitteln zugeordnetes Bildverarbeitungssystem erwiesen, welches zur Bildaufnahme nahe zu der Anschlußstelle gebracht wird und das Einrichtungen zur Bildauswertung aufweist, in denen der Ausgleich der Lageabweichung berechnet wird, worauf ein entsprechendes Steuersignal abgegeben wird, das zur Steuerung einer Bewegungseinrichtung der Leitungsverlegemittel ausgewertet wird.

Die bei der Durchführung des neuen Verdrahtungsverfahrens im Zuge der Direktverdrahtung erforderlichen Relativbewegung zwischen dem vormontierten Gerät oder Baugruppenelement und den Leitungsverlegemitteln lassen sich grundsätzlich auf verschiedene Weise erzeugen. So können die Leitungsverlegemittel von einem mehrachsig beweglichen programmierbaren Handhabungsgerät oder Industrieroboter bewegt werden. Das vormontierte Gerät oder Baugruppenelement wird dabei vor Beginn der Verdrahtung in einer Ausgangsposition innerhalb des Funktionsbereiches des Handhabungsgerätes oder Industrieroboters angeordnet. Diesem ist eine entsprechende Steuereinheit zugeordnet, in der die für die Verlegewege erforderlichen Wegkoordinaten programmiert sind, derart, daß die Leitungsverlegemittel die im Arbeitsprozeß notwendigen Verfahr- und Positionierbewegungen ausführen und mittels geeigneter Systemkomponenten (Sensorsystem etc.) weitere Funktionen, wie z.B. der erwähnte Lagetoleranzausgleich, mittels geeigneter Systemkomponenten (Sensorsystem etc.) erfüllen.

Alternativ kann aber auch derart vorgegangen werden, daß die Leitungsverlegemittel ortsfest oder an einer ihnen lediglich eine Positionierbewegung erteilenden Positioniereinrichtung angeordnet sind, während das vormontierte elektrische Gerät oder Baugruppenteil mittels eines relativ zu den Leitungsverlegemitteln verfahrbaren Transportmittels bewegt wird. Das Transportmittel ist hierbei ebenfalls mit einer programmierbaren Steuereinheit verbunden, die es erlaubt, vollautomatisch die entsprechenden Verlegewege für die direkt verdrahteten Leitungen zu erzielen. Das Arbeitsergebnis ist deshalb gleich. Welche der beiden Vorgangsweisen im Einzelfall gewählt wird, hängt u. a. von der Art des zu verdrahtenden Gerätes oder Baugruppenelementes ab.

Die auf die erwähnte Weise für die Direktverdrahtung erzeugte Relativbewegung zwischen dem vormontierten elektrischen Gerät oder Baugruppenelement und den Leitungsverlegemitteln kann an sich in Abhängigkeit von den örtlichen Gegebenheiten innerhalb des Gerätes bzw. des Baugruppenelementes beliebig gewählt werden, wobei auch krummlinige Verlegungswege möglich sind. In der Regel ist es aber zweckmäßig, wenn diese Relativbewegung zumindest abschnittsweise im wesentlichen geradlinig ist, so daß sich zumindest abschnittsweise gerade Verlegungswege ergeben.

Wenn an der jeweiligen Anschlußstelle keine Durchverdrahtung stattfindet, wird die Leitung unmittelbar an den Leitungsverlegemitteln oder durch entsprechende Ausbildung der Schneidklemme unmittelbar an dieser abgeschnitten, wobei gleichzeitig ein Berührungsschutz für das kontaktierte Le-itungsende hergestellt wird. Da eine eigene Abisolation entfällt, wird an jeder Anschlußstelle im Vergleich zu anderen Anschlußtechniken ein kleines Leitungsstück erspart, was über die für die Gesamtverdrahtung erforderliche Länge der Endlosleitung eine spürbare Einsparung bedeutet.

Wie bereits eingangs erwähnt, kann das neue vollautomatische Verfahren der Direktverdrahtung ohne Vorkonfektionierung von Leitungen etc. an sich auf alle elektrischen Geräte und Baugruppenelemente angewandt werden. Es wurde aber gefunden, daß ein sehr interessantes Einsatzgebiet darin besteht, es zur automatischen Verdrahtung von Leuchten oder deren Teilen zu verwenden. Solche Leuchten haben nämlich einen vehältnismäßig großen Leuchtenkasten, dessen Abmessungen mit Rücksicht auf die darin unterzubringenden Leuchtkörper, wie Gasentladungslampen etc., gewählt sind und einige standardisierte zugeordnete Schaltelemente, die in dem Leuchtenkasten untergebracht sind. Die Verdrahtung der Anschlußstellen dieser Schaltelemente erfolgt heute durchweg manuell; sie ist teuer und aufwendig.

Das neue Verdrahtungsverfahren wird mit zweckentsprechend gestalteten Leitungsverlegemitteln durchgeführt, die es erlauben, die einzelnen, zum Arbeitsprozeß erforderlichen Funktionen auszuführen. Eine für diesen Zweck besonders geeignete Ausführungsform solcher Leitungsverlegemittel ist Gegenstand des Patentanspruchs 18, dessen Oberbegriff von einem Stand der Technik ausgeht, wie er durch die aus den DE-A1 3606 059, 36 11 805 und 38 20 636 sowie die DE-A2 1 290 215 und 1 290 210 bekannten Leitungsverlegewerkzeuge gegeben ist.

Gestellt ist die Aufgabe, Leitungsverlegemittel zu schaffen, die insbesondere bei der neuen Direktverdrahtung eine vollautomatische, einwandfreie Fixierung und Kontaktierung der Leitung an der jeweiligen Anschlußstelle gewährleisten.

Zur Lösung dieser Aufgabe weist das in den Leitungsverlegemitteln enthaltene Verlegewerkzeug erfindungsgemäß die Merkmale des kennzeichnenden Teils des Patentanspruchs 18 auf.

Durch die Anordnung eines in der Nähe der Mündung des Führungskanales oder -rohres der Leitung beweglich angeordneten Druckgliedes für die aus der Mündung austretende Leitung wird erreicht, daß die Leitung in diesem Bereich ausgerichtet und einwandfrei abgestützt in die Kontaktierzone der Anschlußstelle eingedrückt und das Leitungsverlegewerkzeug sodann seitlich einfach von der Anschlußstelle wegbewegt werden kann. Damit läßt sich eine hohe Verdrahtungssicherheit im Bereiche der Anschlußstellen gewährleisten, während gleichzeitig jegliche Nacharbeit entfällt.

Das Druckglied ist in einer vorteilhaften Ausführungsform ein an dem Gehäuse oder an einem mit diesem verbundenen Teil des Verlegewerkzeugs längsverschieblich geführter Stempel, der in der Regel parallel zu dem ebenfalls als Stempel ausgebildeten sogenannten Verlegefinger des Verlegewerkzeugs im Abstand zu diesem angeordnet ist, so daß der Leiter beim Eindrücken in die Kontaktierzone an zwei im gleichen Abstand voneinander liegenden Stellen abgestützt ist. Die Mündung des Führungskanals oder -rohres des Verlegewerkzeuges ist dabei seitlich an dem Verlegefinger auf der dem Druckglied zugewandten Seite angeordnet, wobei das Druckglied und der Verlegefinger, quer zu der Längsrichtung des aus der Mündung des Führungskanales oder -rohres austretenden Leiters gemessen, zumindest bereichsweise eine etwa gleiche Breite aufweisen können. Damit läßt sich eine sehr einfache Gestaltung der Anschlußstelle erzielen.

Um die Leitung an einer Anschlußstelle abzuschneiden, kann bspw. ein Schneidklemmenkontakt verwendet werden, der eine Abschneidkante aufweist, die beim Eindrücken des Leiters in die Kontaktierzone wirksam wird. In diesem Falle genügt es, an dem Verlegewerkzeug das erläuterte Druckglied vorzusehen. Wird auf eine solche Abschneidkante an der Anschlußstelle verzichtet, so wird eine an dem Verlegewerkzeug vorhandene gesteuerte Abschneideinrichtung für die Leitung verwendet, die ein in dem Bereich zwischen der Mündung des Führungskanales und dem Druckglied beweglich angordnetes Abschneidemesser aufweist. Dieses Abschneidemesser ist unmittelbar an dem Verlegefinger wirkend gelagert, wobei der Rand des Führungskanals als Gegenmesser ausgebildet ist. Das Abschneiden des Leiters kann sowohl neben der Kontaktierzone als auch unmittelbar in der Kontaktierzone selbst erfolgen.

Der Verlegefinger des Verlegewerkzeugs schließlich ist an dessen Gehäuse oder an dem mit diesem verbundenen Teil in der Regel fest angeordnet; er kann aber auch beweglich gelagert und mit einer eigenen Stellvorrichtung gekuppelt sein, an seinem vorderen Ende ist es zum Zusammenwirken mit Führungsmitteln an der jeweiligen Anschlußstelle ausgebildet.

Wie bereits erläutert, läßt sich das neue Verfahren der Direktverdrahtung besonders einfach unter Verwendung von Anschlußstellen durchführen, deren Kontaktierzonen in Schneidklemmtechnik gestaltet sind. Dieses ist erläutert bspw. in der Zeitschrift "Messen + Prüfen/Automatik", Heft Juli/August 1982, s. 491, 492; bezüglich der Gestaltung entsprechender Schneidklemmen oder Schneidklemmkontakte sei beispielhaft verwiesen auf DE-U 88 04 388, FR-A1 2330 159 und US-A-2501 187. Ausgehend von diesem Stand der Technik ist die Aufgabe gestellt, eine Anschlußstelle zur Verwendung bei dem eingangs genannten Verfahren, unter Benutzung der erwähnten Leitungsverlegemittel, zu schaffen, die so gestaltet ist, daß sie auf einfache wirksame Weise eine betriebssichere Kontaktierung und Fixierung der angeschlossenen Leitung gewährleistet und gleichzeitig die automatische Verfahrensdurchführung nicht behindert.

Zur Lösung dieser Aufgabe ist die Anschlußstelle erfindungsgemäß mit den Merkmalen des kennzeichnenden Teils des Patentanspruchs 23 ausgebildet.

Die an dem Gehäuse der Anschlußklemme vorgesehene schlitz- oder nutartige Vertiefung gewährleistet zum einen eine berührungssichere Verwahrung des abgeschnittenen Leitungsendes, ohne daß dazu zusätzliche Verfahrensschritte oder Maßnahmen erforderlich wären. Zum andern kann sie erforderlichenfalls noch eine Zentrierung des Verlegefingers und/oder des Druckgliedes des Verlegewerkzeugs beim Einführen der Leitung in die Kontaktierzone bilden. Der verwendete Schneidklemmkontakt selbst bewirkt dabei beim Einführen der Leitung einen gewissen selbsttätigen Höhenausgleich, weil es nur darauf ankommt, daß der Leiter innerhalb eines gewissen Höhentoleranzbereiches fest in dem Schneidklemmsitz aufgenommen ist.

Der Einführschlitz des Gehäuses an der Anschlußstelle kann eine Klemmfixierung der eingedrückten Leitung bewirkende Breite aufweisen, so daß diese unabhängig von der eigentlichen Kontaktierzone festgelegt ist. Auch kann die Vertiefung in dem Gehäuse beidseitig von Schneidklemmkontakten begrenzt oder ein- bzw. beidseitig von einem Schneidklemmkontakt angeordnet sein.

Das erfindungsgemäße Verfahren wird im folgenden anhand eines Ausführungsbeispiels unter Bezugnahme auf die Zeichnung erläutert. In der Zeichnung zeigen:
- Fig.1: einen nach dem erfindungsgemäßen Verfahren zu verdrahtenden vormontierten Leuchtenkasten, in perspektivischer schematischer Darstellung,
- Fig.2: die erfindungsgemäß gestalteten Anschlußstellen eines Vorschaltgerätes des Leuchtenkastens nach Fig. 1, in perspektivischer Teildarstellung und in einem anderen Maßstab,
- Fig. 3: eine Anschlußstelle der Anordnung nach Fig. 2, in einer Draufsicht und in einer Teildarstellung sowie in einem anderen Maßstab,
- Fig. 4: eine Anschlußstelle der Anordnung nach Fig. 2, in abgewandelter Ausführungsform, in einer Draufsicht entsprechend Fig. 3,
- Fig. 5 bis 7: eine Anschlußklemme einer der Anschlußstellen der Anordnung nach Fig. 2, geschnitten längs der Linie V-V der Fig. 3 bzw. der Linie VI-VI und der Linie VII-VII der Fig. 5, in einer Seitenansicht,
- Fig. 8: die erfindungsgemäß ausgebildeten Anschlußstellen des Klemmblockes des Leuchtkastens nach Fig. 1, in einer perspektivischen schematischen Darstellung und in einem anderen Maßstab,
- Fig. 9: die erfindungsgemäß gestalteten Anschlußstellen einer Lampenfassung des Leuchtenkastens nach Fig. 1, in einer perspektivischen Darstellung und in einem anderen Maßstab,
- Fig.10: eine Einrichtung zur Durchführung des erfindungsgemäßen Verfahrens mit Hilfe eines Industrieroboters, in einer schematischen Darstellung und in einer Seitenansicht,
- Fig.11: die Einrichtung nach Fig. 10, in der Draufsicht,
- Fig.12: eine Einrichtung zur Durchführung des erfindungsgemäßen Verfahrens mit Hilfe eines Portal-Handhabungsgerätes in schematischer Darstellung, in einer Seitenansicht,
- Fig.13: eine weitere Ausführungsform einer Einrichtung zur Durchführung des erfindungsgemäßen Verfahrens, unter Verwendung eines Handhabungsgerätes mit einem verfahrbaren Transporttisch, in schematischer Darstellung und in einer Seitenansicht,
- Fig.14 bis 20: das Verlegewerkzeug der Einrichtung nach den Fig. 10, 11, in schematischer ausschnittsweiser Darstellung, in der Zuordnung zu der Anschlußstelle eines Vorschaltgerätes des Leuchtenkastens nach Fig.1, unter Veranschaulichung verschiedener zeitlich aufeinanderfolgenden Phasen des Ablaufes des erfindungsgemäßen Verfahrens beim Anschluß der endlos zugeführten Leitung an die erste Anschlußstelle,
- Fig. 21 bis 29: die Anordnung nach den Fig. 14 bis 20, unter Veranschaulichung zeitlich aufeinanderfolgender Schritte des Verfahrensablaufs nach dem Fixierung des Leitungsendes, während der Verlegung der Leitung zu der nächstfolgenden Anschlußstelle, beim Kontaktieren und anschließenden Abschneiden der Leitung an dieser Anschlußstelle, jeweils in einer entsprechenden Darstellung,
- Fig. 30: den Leuchtenkasten nach Fig. 1, in dem Verdrahtungszustand nach dem Abschluß des anhand der Fig. 14 bis 29 veranschaulichten Abschnitts der Verdrahtung, in einer Draufsicht und in schematischer Darstellung, sowie in einem anderen Maßstab,
- Fig. 31 bis 33: die Leitungsverlegemittel der Einrichtung nach den Fig. 10, 11 in der Zuordnung zu einem weiteren Vorschaltgerät des Leuchtenkastens nach Fig. 1, in einer Darstellung ähnlich Fig. 14 bis 19, unter Veranschaulichung zeitlich aufeinanderfolgender Schritte des Ablaufs des erfindungsgemäßen Verfahrens bei der Herstellung eines nachfolgenden Verdrahtungsabschnitts, und
- Fig. 34: den Leuchtenkasten nach Fig. 30, in dem Zustand nach der Herstellung des mit dem Verfahren nach den Fig. 31 bis 33 hergestellten Verdrahtungsabschnittes.

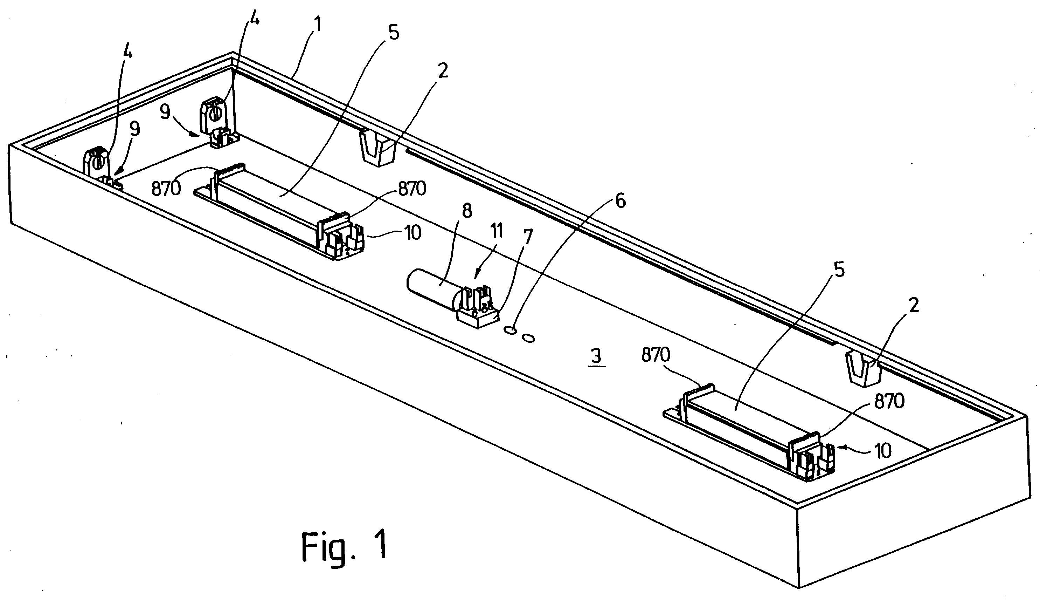

Das Verfahren zur Direktverdrahtung elektrischer Geräte und Baugruppenelemente wird im folgenden anhand der Verdrahtung eines in Fig. 1 dargestellten rechteckigen Leuchtenkastens 1 für zwei nicht weiter veranschaulichte stabförmige Gasentladungsröhren beschrieben. Betriebsmäßig ist der Leuchtenkasten durch eine lichtdurchlässige Acrylglashaube oder einen Reflektor abgedeckt, die bzw. der in Halterungen 2 eingeklemmt wird und im übrigen nicht weiter dargestellt ist.

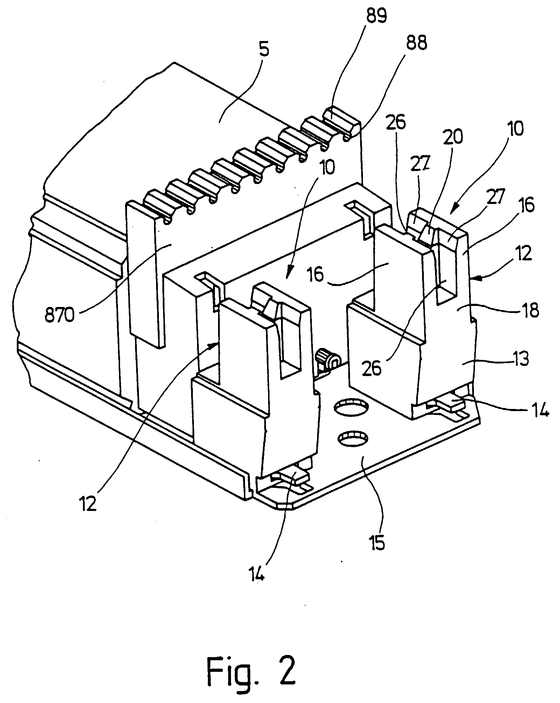

Der Leuchtenkasten ist bereits insoweit vormontiert, als die zur Aufnahme und zum Betrieb der Gasentladungslampen erforderlichen elektrischen Schaltelemente nach einem vorgegebenen Lageplan lagerichtig fest auf dem Kastenboden 3 befestigt, bspw. angeschraubt worden sind. Im einzelnen sind in der Nähe der Kastenstirnwände jeweils paarweise einander gegenüberliegend vier Lampenfassungen 4 bekannter Bauart vorgesehen, denen zwei magnetische Vorschaltgeräte 5 zugeordnet sind, die etwa auf der Mittellinie des Kastenbodens 3 liegend beidseitig von Leitungseinführöffnungen 6 in gleichen Abständen von den Kastenstirnwänden angeordnet sind. Neben den Leitungseinführöffnungen 6 ist ebenfalls auf der Mittellinie des Kastenbodens 3 liegend an diesem ein Isoliermaterialsockel 7 befestigt, der einen Kondensator 8 trägt. An den Lampenfassungen 4, den Vorschaltgeräten 5 und dem Isoliermaterialsockel 7 sind jeweils Anschlußstellen für elektrische Zuleitungen vorgesehen, die an den Lampenfassungen 4 mit 9, an den Vorschaltgeräten mit 10 und an dem Isoliermaterialsockel 7 mit 11 bezeichnet sind. Diese Anschlußstellen 9, 10, 11 sind alle nach dem gleichen Grundprinzip mit einer Kontaktierzone nach der Schneidklemmtechnik gestaltet. Ihre Ausbildung ist im einzelnen aus den Fig. 2 bis 9 zu ersehen; sie sei insbesondere anhand der Anschlußstelle 10 eines Vorschaltgerätes 5 unter Bezugnahme auf die Fig. 2 bis 7 erläutert:

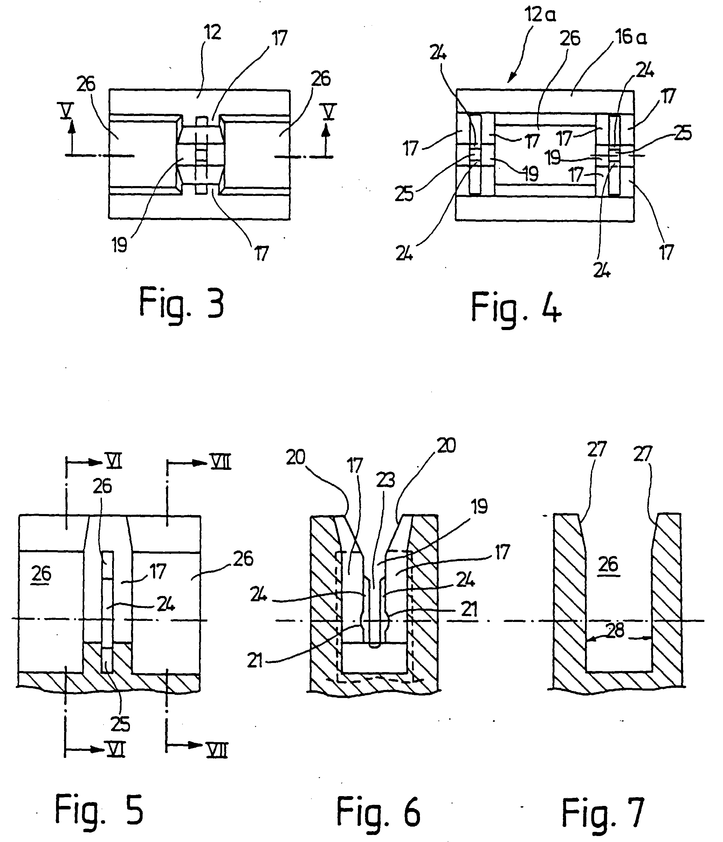

Jede Anschlußstelle 10 weist ein aus Isoliermaterial bestehendes Gehäuse 12 von im wesentlichen rechteckiger Querschnittsgestalt auf, das auf ein ebenfalls aus Isoliermaterial hergestelltes Sockelteil 13 aufgesetzt ist, so daß sich eine einheitliche Anschlußklemme ergibt, die bei 14 an einer ausgestanzten hochgebogenen Lasche einer Grundplatte 15 des Vorschaltgerätes 5 befestigt ist. Die beiden Seitenwände 16 des nach oben zu offenen Gehäuses 12 tragen auf ihrer Innenseite zwei einander gegenüberliegende, angeformte Rippen 17, die etwa mittig zwischen den beiden Stirnseiten 18 des Gehäuses 12 liegen und zwischen sich einen leicht keilförmig oder parallelflankig begrenzten Einführschlitz 19 (Fig. 6) begrenzen, der an seiner Oberseite durch Einführschrägen 20 verbreitert ist. In seinem unteren Bereich ist der Einführschlitz bei 21 in einem teilkreisförmigen Bereich örtlich etwas erweitert.

In die Rippen 17 erstrecken sich von unten her bis etwa zur Höhe der Einführschrägen 20 zwei einander gegenüberliegende schmale Nuten 22, die die beiden einen randoffenen Schneidklemmschlitz 23 begrenzenden Schenkel 24 eines aus Federstahl oder -bronze hergestellten Schneidklemmkontaktes 25 aufnehmen. Der schmale, plättchenförmige, im wesentlichen U-förmige Schneidklemmkontakt 25 ist in dem Gehäuse 12 bis auf die an den Schenkeln 24 ausgebildeten, dem Schneidklemmschlitz 23 zugewandten Schneidabschnitte allseitig in das Isoliermaterial des Gehäuses 12 eingebettet, wobei seine beiden Schenkel 24 in den Nuten 22 begrenzt beweglich geführt sind. An ihn ist jeweils in nicht weiter dargestellter Weise ein Wicklungsende des Vorschaltgerätes 5 angeschlossen. Er bildet gemeinsam mit dem Schneidklemmschlitz 23 die Kontaktierzone der Anschlußstelle 10.

Wie insbesondere aus den Fig. 3 bis 7 zu entnehmen, weist das Gehäuse 12 beidseitig an die Rippen 17 und damit den Einführschlitz 19 anschließend jeweils eine nutartige Vertiefung 26 rechteckiger Querschnittsgestalt auf, die sich neben dem Einführschlitz 19 zur Oberseite des Gehäuses 12 hin öffnet. Die beiden nutartigen Vertiefungen 26 sind zueinander und mit dem Einführschlitz 19 fluchtend angeordnet. Sie sind oben ebenfalls durch eine Einführschräge 27 begrenzt. Die Fig. 5,7 zeigen, daß die Tiefe der nutartigen Vertiefungen 26 größer ist als jene des Einführschlitzes 19 und daß auch ihre Weite 28 wesentlich größer als die Weite des Einführschlitzes 19 ist.

Die Abmessungen der einzelnen Teile sind so gewählt, daß bei einem durch den Einführschlitz 19 eingedrückten isolierten Leiter die Isolation in dem Schneidklemmschlitz 23 von den Schenkeln 24 des Schneidklemmkontaktes 25 aufgeschnitten wird, wobei gleichzeitig eine gasdichte Kontaktierung zwischen dem Schneidklemmkontakt 25 und dem sich an der Klemmstelle verformenden Leiter erfolgt. Mit seiner Isolierung wird der eingedrückte Leiter gleichzeitig in dem Einführschlitz 19 zwischen den beiden Rippen 17 festgeklemmt, wobei die Erweiterung bei 21 dazu dient, eine Verrastung der Leitung an deren Isolation beim Eindrücken in den Einführschlitz 19 zu gewährleisten. Die so fixierte angeschlossene Leitung verläuft durch eine der nutartigen Vertiefungen 26, während ihr abgeschnittenes Ende in der anderen nutartigen Vertiefung 26 liegt, wie dies im einzelnen noch erläutert werden wird. Die Weite und Tiefe der nutartigen Vertiefungen 26 sowie deren axiale Länge sind derart bemessen, daß sich für das abgeschnittene Ende der Leitung automatisch ein Berührungsschutz ergibt. Das bedeutet, daß der genormte Fühlfinger bei der Prüfung auf Berührungssicherheit nicht bis zu dem blankliegenden abgeschnittenen Ende in der Tiefe der zugeordneten nutartigen Vertiefung 26 vordringen kann.

Bei der beschriebenen Ausführungsform des Gehäuses 12 sind beidseitig des Einführschlitzes 19 zwei miteinander fluchtende nutartige Vertiefungen 26 vorgesehen, deren Weite und Tiefe wesentlich größer als der Durchmesser der aufzunehmenden Leitung ist. Es ist auch denkbar, eine der nutartigen Vertiefungen 26 wegzulassen, was insbesondere dann infragekommt, wenn die Leitung, wie dies ebenfalls noch erläutert werden wird, lediglich durch die Anschlußstelle durchgehend verlegt wird. In Einzelfällen können auch beide nutartigen Vertiefungen 26 in Wegfall kommen.

Eine abgewandelte Ausführungsform des Gehäuses 12 zeigt die Fig. 4 in der Draufsicht: Bei dieser Ausführungsform ist lediglich eine nutartige Vertiefung 26 vorhanden, die in dem Gehäuse 12a beidseitig jeweils durch ein Rippenpaar 17 mit einem dazwischenliegenden Einführschlitz 19 und einem mit seinen Schenkeln 24 in diesen ragenden Kontaktelement 25 begrenzt ist. Die Rippenpaare sind in dem Gehäuse 12a jeweils endseitig mit den Seitenwänden 16a bündig angeformt und mit ihren Einführschlitzen 19 auf die Längsachse der nutenartigen Vertiefung 26 ausgerichtet.

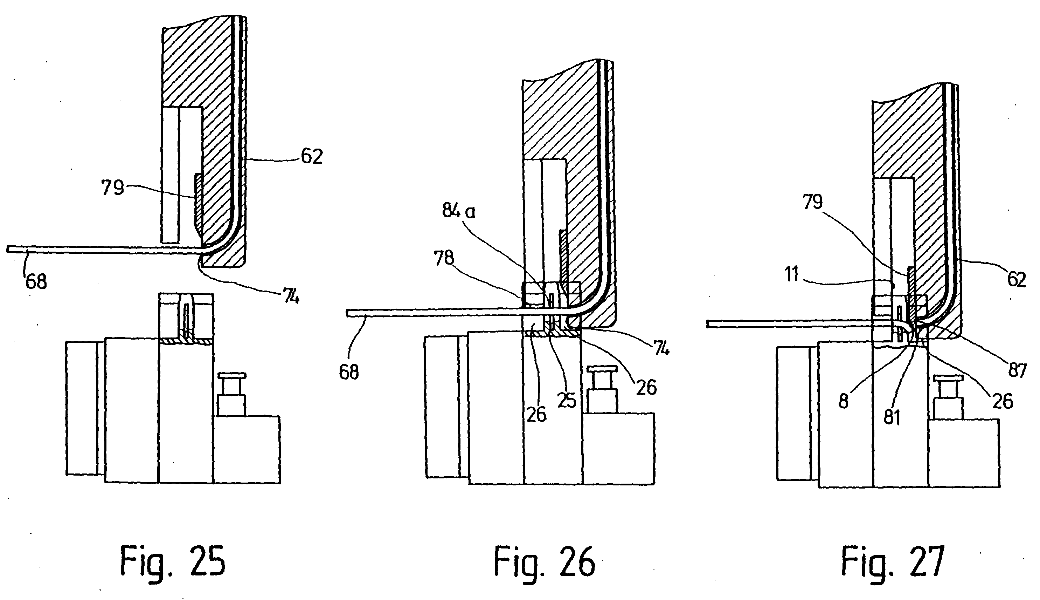

Während bei der Ausführungsform nach den Fig. 2, 3 ein abgeschnittenes Leitungsende neben der von dem Schneidklemmelement 25 gebildeten Kontaktierungszone liegt (vergl. bspw. Fig. 27 bis 29), ist bei der Ausführungsform nach Fig. 4 gewährleistet, daß das abgeschnittene Ende sich in der von den beiden Schneidkontakten 25 begrenzten Kontaktierzone, d.h. innerhalb des bis auf den Einführschlitz allseitig geschlossenen Gehäuses 12a befindet.

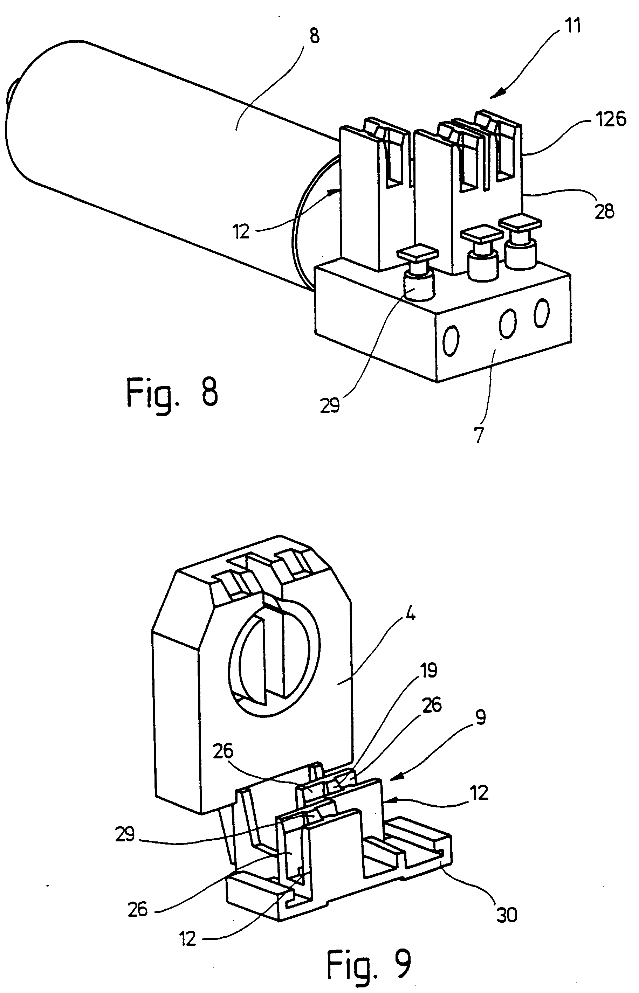

Die auf dem Isoliermaterialsockel 7 angeordneten Anschlußstellen 11 sind, wie aus Fig. 8 zu entnehmen, grundsätzlich gleich wie die Anschlußstellen 10 ausgebildet. Es wird deshalb insoweit auf die Erläuterungen zu den Fig. 2 bis 7 Bezug genommen. Gleiche Teile sind mit gleichen Bezugszeichen versehen.

Insgesamt sind auf dem Isoliermaterialsockel 7 drei Anschlußstellen 11 angeordnet, von denen zwei zu einer Anschlußklemmeinheit zusammengefaßt sind, die mit 28 bezeichnet ist und die ein einheitliches Gehäuse 12b aufweist. Bei 29 sind Klemmen für die interne Verbindung mit den Anschlüssen des Kondensators 8 angedeutet.

Auch die Anschlußstellen 9 der Lampenfassungen 4 sind grundsätzlich entsprechend den Anschlußstellen 10 nach den Fig. 2,3 aufgebaut. In Fig. 9 sind deshalb gleiche Teile wiederum mit gleichen Bezugszeichen versehen, wobei auf die Erläuterungen zu den Fig.2, 3 Bezug genommen ist.

Während die Gehäuse 12, 12b bei den Anschlußstellen 10, 11 (Fig. 2,8) aber mit ihren Einführschlitzen 19 und den nutartigen Vertiefungen 26 in Längsrichtung des Vorschaltgerätes 5 bzw. des Starters 6 und damit des Leuchtenkastenbodens 3 (Fig. 1) weisend angeordnet sind, ist bei den Lampenfassungen 4 die Anordnung derart getroffen, daß die Gehäuse 12 auf einem Befestigungsfuß 30 der jeweiligen Lampenfassung 4 mit quer zu der Längsrichtung der einzusetzenden Gasentladungslampen und damit des Lampenkastenbodens 3 verlaufende Einführschlitzen 19 und nutartigen Vertiefungen 26 befestigt sind. Anzuschließende Leitungen müssen deshalb bei den Lampenfassungen 4 rechtwinklig zu der Längserstreckung des Lampenkastens 3 verlaufend in den Einführschlitz 19 eingedrückt werden.

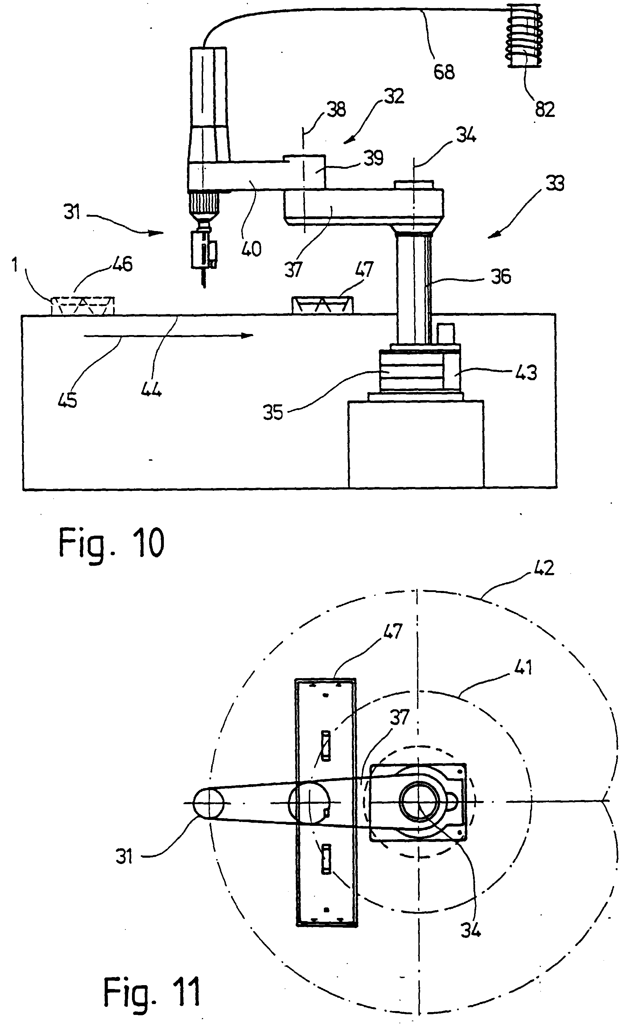

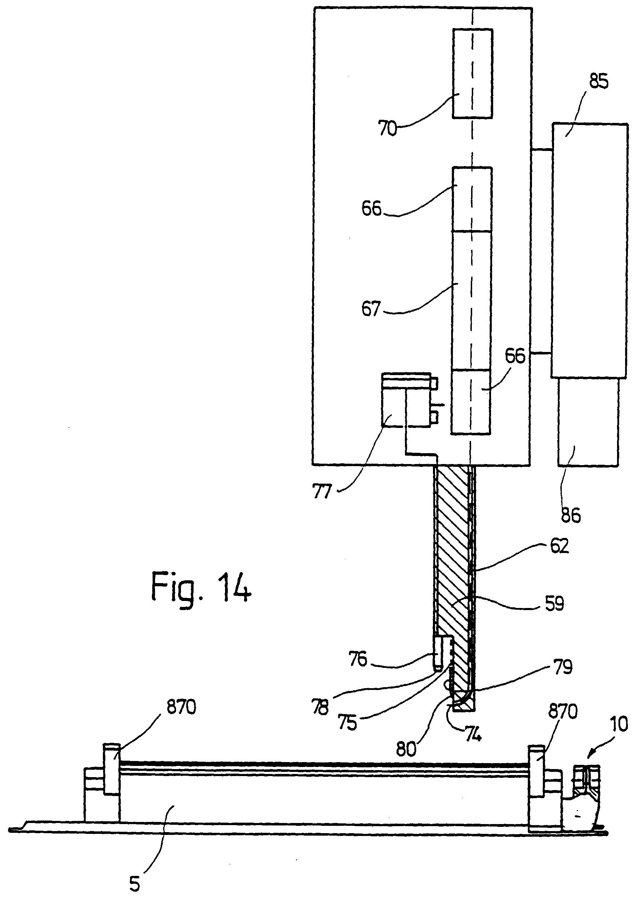

Die Verdrahtung des insoweit mit seinen Schaltelementen 4,5,7 und deren Anschlußstellen 9,10,11 beschriebenen Leuchtenkastens 1 erfolgt mit Hilfe eines Industrieroboters oder eines Handhabungsgerätes nach den Fig. 10,11 bzw. 12, 13 der die Leitungsverlegemittel bewegt, wie dies im folgenden anhand der Fig. 13 ff beschrieben werden wird:

Die allgemein mit 31 bezeichneten Leitungsverlegemittel sitzen bei der Einrichtung nach den Fig. 10, 11 an dem zweiteiligen Arm 32 eines Industrieroboters 33, der eine um eine erste ortsfeste vertikale Achse 34, bspw. von einem Schrittmotorantrieb 35, drehbare Säule 36 aufweist, die ein erstes Armteil 37 trägt, das im Bereiche seines freien Endes über eine eine zu der ersten Drehachse 34 parallele vertikale zweite Drehachse 38 bildende, mit einem inkrementalen Drehantrieb versehene Schwenklagerung 39, mit einem zweiten Armteil 40 verbunden ist, das an seinem äußeren Ende die Leitungsverlegungsmittel 31 trägt. Die beiden Antriebe 35, 39 können die zweite Drehachse 38 auf einem Kreis 41 um die erste Drehachse 34 und die Leitungsverlegungsmittel 31 im gestreckten Zustand des Armes 32 auf einer im wesentlichen kreisförmigen Bahnkurve 42 bewegen, wobei ein der Antriebssäule 36 zugeordneter Hubantrieb 43 eine gesteuerte vertikale Auf- und Abbewegung des Armes 32 und damit der Leitungsverlegungsmittel 31 ermöglicht. Dem Industrieroboter 33 ist ein ortsfester Arbeitstisch 44 mit darin integriertem, durch einen Pfeil 45 (Fig. 10) angedeuteten Transportmechanismus zugeordnet, der es erlaubt, auf der horizontalen Arbeitsfläche des Arbeitstisches 44 aufeinanderfolgend vormontierte Leuchtenkästen 1 nach Fig. 1 aus einer abseitigen Bereitschaftsstellung bei 46 (Fig. 10) in den von der im wesentlichen kreisförmigen Bahnkurve 42 umgrenzten Funktionsbereich der Leitungsverlegemittel 31 zu bringen, wie dies durch die in den Fig. 10,11 veranschaulichte Arbeitsstellung des Leuchtenkastens 1 bei 47 angedeutet ist. In dieser Arbeitsstellung 47 ist der Leuchtenkasten 1 auf dem Arbeitstisch 44 lagerichtig festgespannt. Die zugehörigen Spannmittel sind bekannter Art; sie sind in den Fig. 10,11 nicht weiter dargestellt. Innerhalb des Funktionsbereiches können die Leitungsverlegemittel 31 von dem programmierbaren Industrieroboter 33 an jede beliebige Stelle innerhalb des Leuchtenkastens 1 gebracht und auf jedem vorprogrammierten definierten Weg innerhalb des Leuchtenkastens 1 bewegt werden.

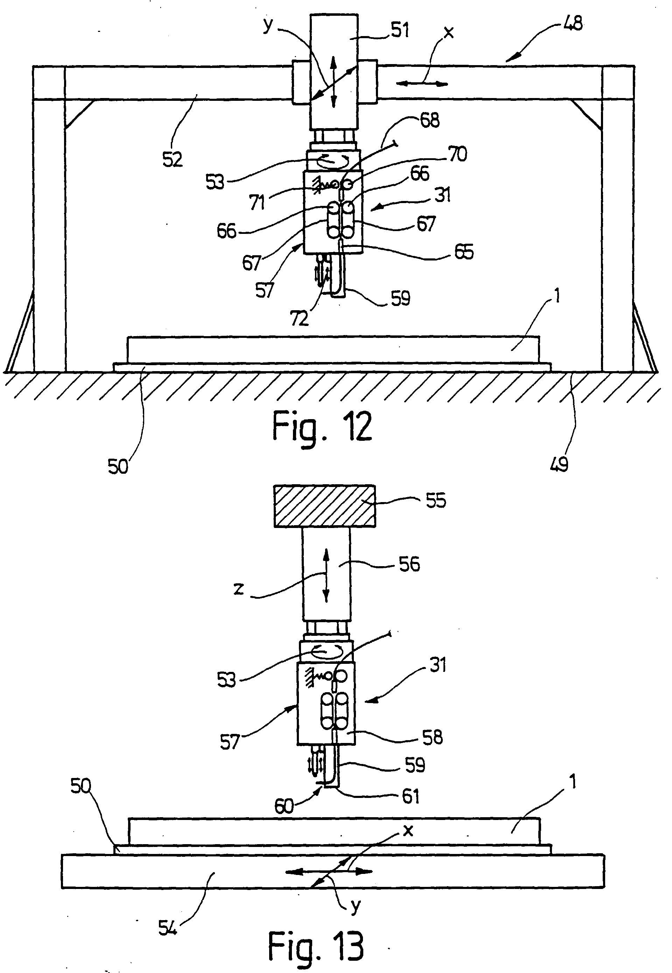

Grundsätzlich Gleiches gilt bei Verwendung des in Fig. 12 dargestellten Portal-Handhabungsgerätes 48, bei dem der vormontierte Leuchtenkasten 1 auf einem ortsfesten Arbeitstisch 49 auf einer Leuchtenkastenaufnahme 50 lagerichtig festgespannt ist und die Leitungsverlegemittel 31 an einem Wagen 51 angeordnet sind, der an einem Portal 52 frei programmierbar in der durch einen Doppelpfeil angedeuteten X-Richtung in Längsrichtung des Leuchtenkastens und einer dazu querverlaufenden, ebenfalls durch einen Doppelpfeil angedeuteten Y-Richtung querverfahrbar gelagert ist. Außerdem sind die Leitungsverlegemittel 31 um eine vertikale Drehachse 53 (c-Achse) drehbar an dem Wagen 51 gelagert. Jeder der Bewegungsachsen X,Y,c sind, ebenso wie der Hubachse (z-Achse) eigene inkrementale Schrittantriebe zugeordnet, die,von einer frei programmierbaren Steuereinheit angesteuert, die Leitungsverlegemittel 31 innerhalb des fest aufgespannten, vormontierten Leuchtenkastens 31 an jede beliebige Stelle auf dem jeweils vorprogrammierten Weg bringen können.

Die zur Leitungsverlegung, d.h. zur Verdrahtung der Anschlußstellen 9,10,11 des vormontierten Leuchtenkastens 1 erforderliche Relativbewegung zwischen den Leitungsverlegungsmitteln 31 und dem vormontierten Leuchtenkasten 1 kann schließlich auch mit der Einrichtung nach Fig. 13 erzielt werden. Dabei ist der vormontierte Leuchtenkasten 1 mittels der Leuchtenkastenaufnahme 50 auf einem XY-Tisch 54 aufgespannt, dessen Bewegungsachsen X,Y jeweils durch Doppelpfeile angedeutet sind. Die Leitungsverlegemittel 31 sind von einer oberhalb des XY-Tisches 54 an einem ortsfesten Träger 55 angeordneten Positioniereinrichtung 56 getragen, die den Leitungsverlegemitteln 31 eine Hubbewegung in der Z-Richtung (durch einen Doppelpfeil angedeutet) und eine Drehbewegung um die Vertikalachse 53 (c-Achse) erteilen können. Auch in diesem Falle sind dem XY-Tisch 54 und der Positioniereinrichtung 56 inkrementale Antriebe zur Bewegung in der XY- bzw. der zc-Achse zugeordnet, die von einer frei programmierbaren Steuereinheit angesteuert werden, derart, daß die Leitungsverlegeeinheit 31 an jedem beliebigen Ort innerhalb des Leuchtenkastens 1 auf dem jeweils programmierten Weg gebracht werden kann.

Die Leitungsverlegungsmittel 31 ihrerseits weisen im wesentlichen ein sogenanntes Leitungsverlegewerkzeug 57 mit einem gegebenenfalls mehrteiligen Gehäuse 58 auf, das an dem Arm 32 des Industrieroboters 33 (Fig. 10) oder dem Wagen 51 (Fig. 12) bzw. an der Positioniereinrichtung 56 (Fig. 13) befestigt ist. An der Unterseite des Gehäuses 58 ist ein vertikaler Verlegefinger 59 von im wesentlichen rechteckiger Querschnittsgestalt angeordnet, der einen L-förmig gekrümmten Leitungsführungskanal 62 enthält, welcher im Bereiche einer Seitenwand bei 60 in geringem Abstand von der ebenen Bodenfläche 61 des Verlegefingers 59 mündet. Der in dem Verlegefinger 59 enthaltene Leitungsführungskanal 62 (Fig. 14) findet in dem Gehäuse 57 seine Fortsetzung in einem Führungsrohr 65, dem ein aus zwei Bandrollenpaaren 66 (Fig. 12, 13) und darum geschlungenen endlosen Antriebsbändern 67 bestehender Bandantrieb für eine bei 68 angedeutete Leitung vorgeordnet ist.

Die mit jeweils einem Trum parallel zueinander und in geringem Abstand voneinander geführten Bänder 67 sind über die Bandrollen 66 mit einem inkrementalen Antrieb gekoppelt, der ihnen eine gesteuerte Antriebsbewegung erteilt, die mit der relativen Bahnbewegung zwischen dem vormontierten Leuchtenkasten 1 und den Leitungsverlegemitteln 31 synchronisiert ist, welche durch die Einrichtungen nach den Fig. 10 bis 13 bei der Herstellung der Verdrahtung erzeugt werden kann.

Ein dem Bandantrieb für die Leitung 68 vorgeschaltetes Meßsystem, das aus einem Meßrad 70 und einer elastisch in Eingriffsstellung vorgespannten Antriebsrolle 71 besteht, erlaubt es dabei, die exakte Vorschubbewegung der Leitung 68 unabhängig von dem zwischen den endlosen Bändern 67 des Bandantriebes auftretenden Schlupf zu messen, so daß eine einwandfreie Synchronisierung des Leitungsvorschubs mit der Verfahrbewegung des Roboters 33,des Handhabungsgerätes 48 oder des XY-Tisches 54 gewährleistet ist.

Der Verlegefinger 59 ist in der Regel an dem Gehäuse 57 starr befestigt; er kann aber auch in der vertikalen Z-Achse auf- und abbeweglich gelagert und mit einer entsprechend ansteuerbaren Stelleinrichtung innerhalb des Gehäuses 58 versehen sein. Dies ist durch einen Doppelpfeil 72 in Fig. 12 angedeutet.

Wie beispielsweise aus Fig. 14 zu ersehen, ist im seitlichen Abstand von der die Mündung 74 des Leitungsführungskanals 62 enthaltenden vertikalenen ebenen Seitenfläche 60 des Verlegefingers 59 - oder wie in den Fig. 12, 13 an dem Gehäuse 58 selbst - ein in der Z-Achse vertikal bewegbares Druckglied in Gestalt eines verschieblichen Stempels 76 angeordnet, das über einen zugeordneten Stellantrieb im Inneren des Gehäuses 58 auf- und abbewegbar ist. Die Bewegung des Stempels 76 ist von der Steuereinheit in Abhängigkeit von der Verfahrbewegung der Leitungsverlegemittel 31 programmgemäß gesteuert. Ein mit dem Stempel 76 gekuppelter Sensor 77 (Fig. 14) gibt ein Rückmeldesignal über die jeweils erreichte Stellung der als Druckfläche 78 wirkenden Bodenfläche des Stempels 76 an die Steuereinheit ab, so daß eine exakte Einstellung der Höhenlage der Bodenfläche 78 des Stempels 76 zu der Mündung 74 des Leitungsführungskanales 62 möglich ist.

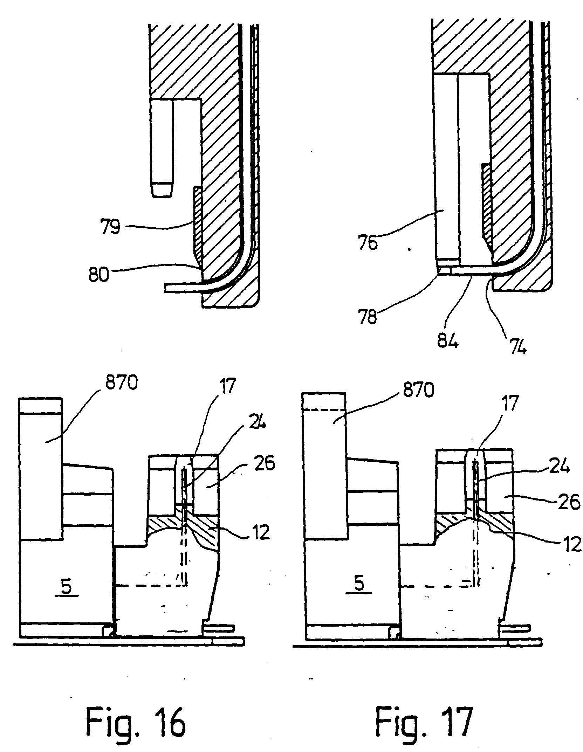

Auf der vertikalen Seitenfläche 60 des Verlegefingers 59 ist schließlich ein Abschneidemesser 79 auf- und abbeweglich gelagert, dessen zugeordneter, in dem Gehäuse 58 untergebrachter Antriebsmechanismus nicht weiter dargestellt ist. Es kann mit der an seinem unteren Ende angeordneten Messerschneide 80 (Fig. 16) aus der in Fig. 14, 16, 17 dargestellten Ruhestellung in eine in Fig. 27 veranschaulichte Arbeitsstellung vorgeschoben werden, in der es das aus der Mündung 74 des Leitungsführungskanals 62 vorragende Ende der Leitung 68 glatt abgeschnitten hat. Dazu hat die Messerkante 80 die Öffnung der Mündung 74 überquert, wobei die Unterseite 81 der Mündungsberandung des Leitungsführungskanals 62 als Gegenmesser dient, wie dies beispielsweise aus Fig. 27 ohne weiteres zu ersehen ist.

Grundsätzlich sind auch Ausführungsformen denkbar, bei denen dem Messer 79 ein eigenes, von dem Verlegefinger 59 getrenntes Gegenmesser zugeordnet ist.

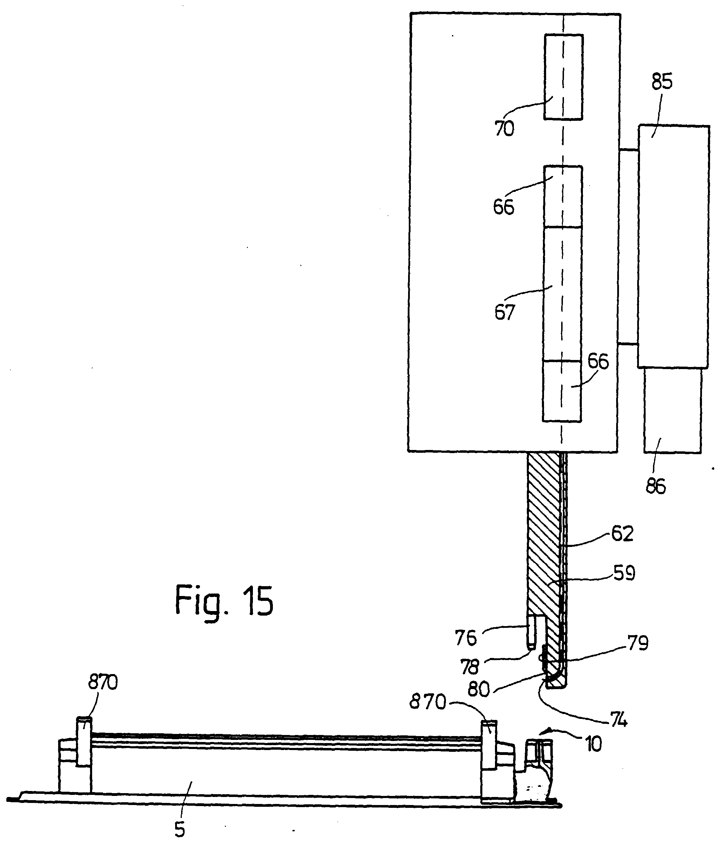

Mit Hilfe des beispielsweise von dem Industrieroboter 33 (Fig. 10, 11) programmgemäß längs vorgegebener Bewegungsbahnen bewegten beschriebenen Leitungsverlegemittel 31 wird ein vormontierter Leuchtenkasten 1, der mit den in erläuterter Weise ausgebildeten Anschlußstellen 9, 10, 11 an vorgegebenen Stellen des Leuchtenkastenbodens 3 versehen ist, in der folgenden Weise automatisch verdrahtet, wobei auf die Fig. 14 bis 34 Bezug genommen wird:

In das Verlegewerkzeug der Leitungsverlegemittel 31 ist eine beispielsweise von einer Spule 82 (Fig. 10) endlos abgezogene, isolierte Leitung 68 eingefädelt. Sie läuft zwischen dem Meßrad 70 und der Andrückrolle 71 sowie zwischen den beiden endlosen Bändern 67 des Bandantriebs durch und wird von diesem durch das Führungsrohr 65 in den L-förmigen Leitungsführungskanal 62 gefördert. Der Bandantrieb hat das vordere Ende der Leitung 68 in der aus den Fig. 12 bis 17 ersichtlichen Weise so weit vorbewegt, daß ein Stück 84 (Fig. 17) aus der Mündung 74 des Leitungsverlegekanals 62 vorragt, das bis unter die Druckfläche 78 des Stempels 76 reicht.

Ein vormontierter Leuchtenkasten 1 wurde in die Arbeitsstellung 47 nach Fig. 10 in den Funktionsbereich des Industrieroboters 33 gebracht und dort auf dem Arbeitstisch 44 lagerichtig festgespannt (Fig. 11). Der Stempel 76 steht in seiner angehobenen Ruhestellung nach Fig. 16; auch das Messer 79 nimmt seine Ruhestellung oberhalb der Mündung 74 ein. Der Bandantrieb 66, 67 steht.

Der entsprechend programmgemäß gesteuerte Industrieroboter 33 bringt die Leitungsverlegemittel 31 mit dem Verlegefinger 59 aus einer abseitigen Ruhestellung in die Nähe der ersten Anschlußstelle, die in diesem Falle eine Anschlußstelle 10 des linken Vorschaltgeräts 5 nach Fig. 1 ist. Dabei kommt der Verlegefinger 59 etwa in die Stellung nach Fig. 14, in der er oberhalb der Anschlußstelle 10 und seitlich gegenüber dieser versetzt steht.

In dieser Stellung des des Verlegefingers 59 stehen an dem Gehäuse 58 angeordnete Lagefühlmittel in Gestalt eines Bildverarbeitungssystems 85 mit seiner Bildaufnahmeeinrichtung 86 oberhalb der Anschlußstelle 10. Das Bildverarbeitungssystem 85 enthält Mittel zur Bildauswertung, mit deren Hilfe es die Lageabweichung des Verlegefingers 59 von der Anschlußstelle 10 errechnet und ein entsprechendes Ausgleichs-Steuersignal erzeugt. Dieses Signal wird in der Steuereinheit in dem Sinne verarbeitet, daß der Industrieroboter 33 - oder eine zwischen diesem und den Leitungsverlegungsmitteln 31 angeordnetes Positioniersystem, ähnlich der Positioniereinrichtung 56 nach Fig.13 - den erforderlichen Lagetoleranzausgleich vornimmt und den Verlegefinger 59 exakt lagerichtig zu der Anschlußstelle 10 positioniert. Wenn dies erreicht ist, nimmt der Verlegefinger 59 die Stellung nach Fig. 16 ein, in der er genau ausgerichtet oberhalb des Gehäuses 12 und dessen nutenartigen Vertiefungen 26 steht.

Der Stempel 76 geht nunmehr in seine untere Betriebsstellung gemäß Fig. 17, in der er mit seiner am Grunde einer Längsnut angeordneten Druckfläche 78 auf dem aus der Mündung 74 des Leitungsführungskanals 92 entsprechend weit vorgeschobenen Leitungsendstück 84 aufliegt und dieses genau horizontal positioniert. Das Leitungsendstück 84 kann dabei erforderlichenfalls noch bis zum Ende der Druckfläche 78 vorgeschoben werden.

Das Verlegewerkzeug der Leitungsverlegemittel 31 und dabei insbesondere deren Verlegefinger 59 und der Stempel 76 werden gleichzeitig entlang der vertikalen Z-Achse nach unten bewegt. Dabei wird das horizontale Leitungsendstück 84 durch den Einführschlitz 19 des Gehäuses 12 an der Anschlußstelle 10 in den Schneidklemmschlitz 23 des Schneidkontaktes 25 eingepreßt, bis das Leitungsstück 84 in der Schlitzverbreiterung 21 (Fig. 6) verrastet. Bei dieser Einpreßbewegung wird von der Oberseite des Leitungsführungskanals 62 und der Druckfläche 78 beidseitig des Einführschlitzes 19 eine gleich große, gleichmäßige Eindrückkraft auf das horizontal gehaltene Leitungsendstück 84 ausgeübt, so daß dieses nicht ausweichen kann und eine einwandfreie Einführung in die Kontaktierzone der Anschlußstelle 10 gewährleistet ist.

Bei dieser Einführ- und Einpreßbewegung wird von den Schneidkanten an den Schenkeln 24 des Schneidklemmelementes die Isolation aufgeschnitten und eine einwandfreie Kontaktierung hergestellt. Gleichzeitig wird das Leitungsendstück 84 von den beiden Rippen 17 beidseitig des Schneidklemmkontaktes 25 unter geringfügiger Verformung seiner Isolation lagefest fixiert.

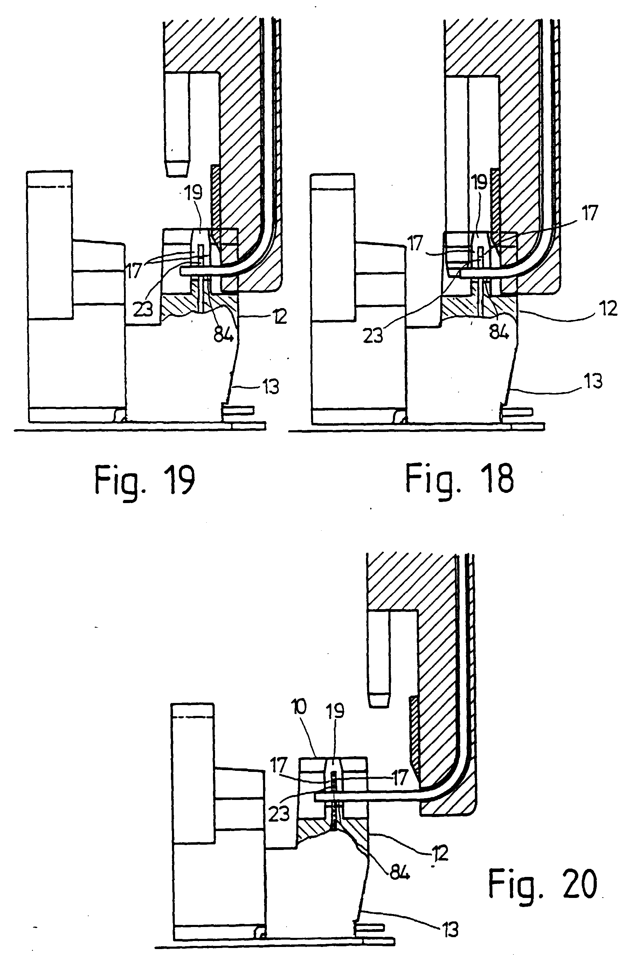

Der Stempel 76 und der Verlegefinger 59 weisen an ihrem vorderen Ende eine im wesentlichen gleiche Breite senkrecht zur Zeichenebene (Fig. 18) auf, die der Breite der nutartigen Vertiefungen 26 entspricht, so daß eine einwandfreie gegenseitige räumliche Zuordnung des Gehäuses 12 zu dem Verlegefinger 59 und dem Stempel 76 beim Eindrücken des Leitungsstückes 84 gewährleistet ist. Die Teile nehmen nunmehr die Stellung nach Fig. 18 ein.

Der Stempel 76 geht nun nach oben in seine End- oder Ruhelage und gibt das Ende des Leitungsstückes frei. Dieser Zustand ist in Fig. 19 veranschaulicht.

Da das Ende des Leitungsstückes 84 in unmittelbarer Nähe der Führungsnut 19 in der nutartigen Vertiefung 26 aufgenommen ist und diese eine solche Länge, Weite und Höhe aufweist, daß die freie Stirnfläche des Leiters von außen her nicht berührt werden kann und da der Schneidklemmkontakt 25 in dem Isoliermaterial des Gehäuses 12 eingebettet und von außen her ebenfalls berührungssicher umschlossen ist, ist damit bereits eine einwandfreie Berührungssicherheit an der Anschlußstelle 10 erreicht.

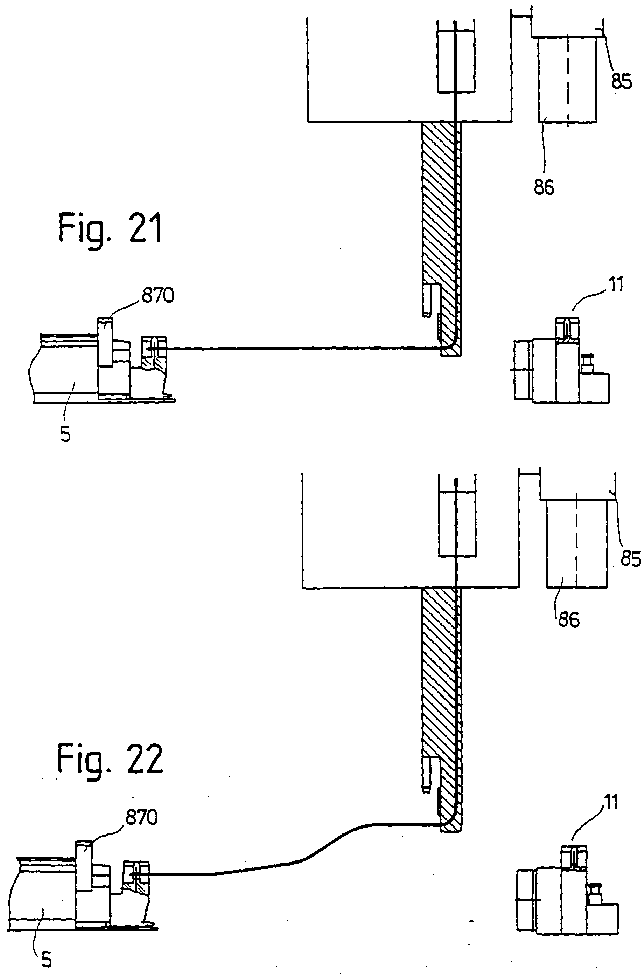

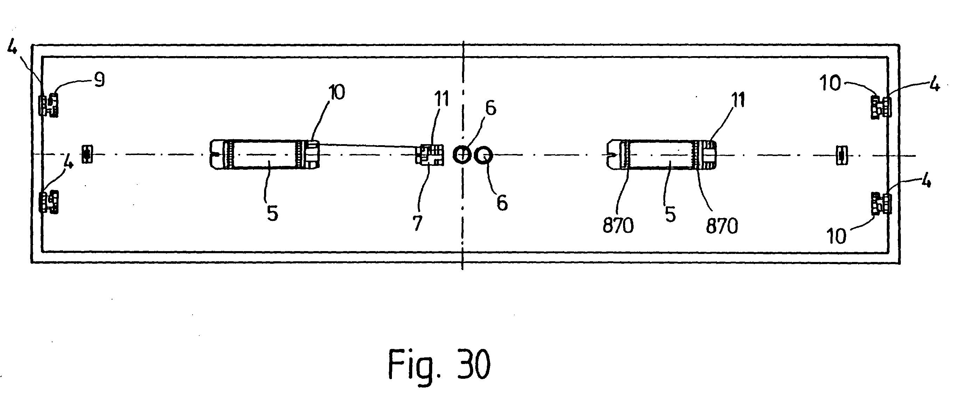

Die Steuereinheit steuert nun die Bewegung des Industrieroboters 33 programmgemäß derart, daß der Verlegefinger 59 von der kontaktierten Anschlußstelle 10 unter Verlegung der Leitung 68 zu der nächsten Anschlußstelle - der Anschlußstelle 11 auf dem Isoliermaterialsockel 7 auf dem aus Fig. 30 ersichtlichen geradlinigen Verlegungsweg verfährt. Dies ist in den Fig. 20, 21 veranschaulicht.

Dabei wird der Bandantrieb 66, 67,gesteuert von der Steuereinheit, synchron mit dieser Verfahrbewegung des Verlegefingers 59 so betätigt, daß sich ein zugfreies Verlegen der Leitung ergibt. Gegebenenfalls kann bei dieser Verfahrbewegung dem Verlegefinger 59 auch eine Höhenbewegung in der Z-Achse erteilt werden, etwa um die verlegte Leitung auf den Kastenboden 3 (Fig. 1) abzulegen oder um einen Höhenunterschied zwischen den Anschlußstellen 10, 11 auszugleichen, wie dies in Fig. 22 angedeutet ist.

In Verlaufe dieser Verfahrbewegung wird der Verlegefinger 59 zunächst lediglich in die Nähe der Anschlußstelle 11 in die Stellung nach Fig. 21 bzw. 22 verbracht, in der das Bildverarbeitungssystem 85 oberhalb der Anschlußstelle 11 steht und deren räumliche Lage erfassen kann, die durchaus auch von unvermeidbaren Montagetoleranzen der Bauelemente beeinflußt sein darf.

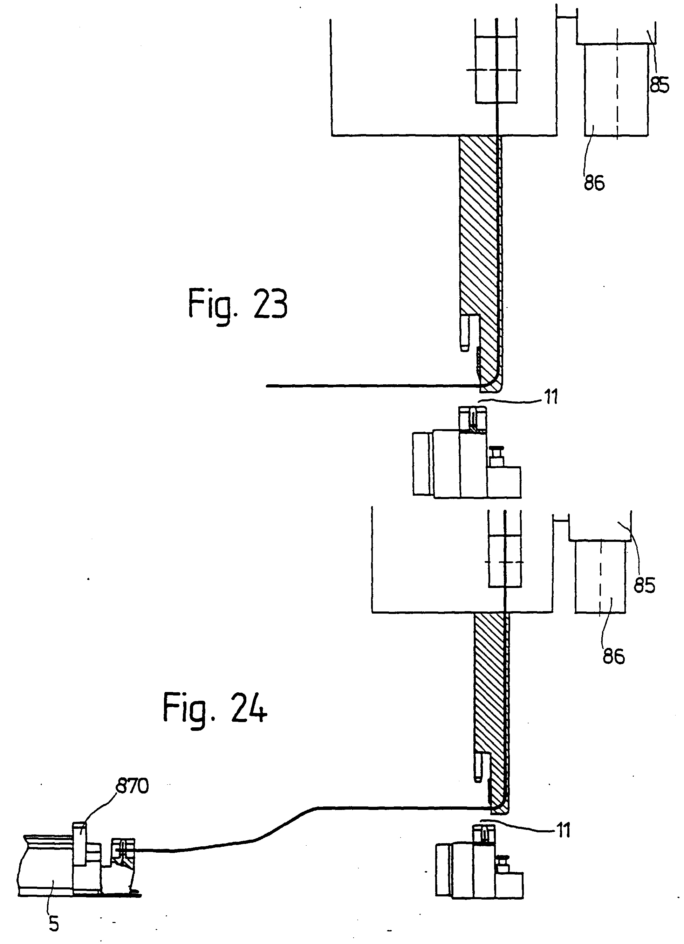

Das Bildverarbeitungssystem 85 ermittelt nun, ännlich wie zuvor bei der Anschlußstelle 10, die Lageabweichung des Verlegefingers 59 von der Anschlußstelle 11 und bewirkt über die Steuereinheit des Industrieroboters 33 den zur exakten Positionierung des Verlegefingers 59 zu der Anschlußstelle 11 erforderlichen Lagetoleranzausgleich. Sowie dieser abgeschlossen ist, nehmen die Teile die Stellung nach Fig. 23 bzw. Fig. 24 ein.

Der Stempel 76 wird nunmehr aus seiner End- oder Ruhestellung in die Arbeitsstellung abgesenkt, in der er mit seiner Druckfläche 78 auf dem aus der Mündung 74 des Leitungsführungskanals 62 austretenden Teil der hier horizontal geführten Leitung 68 aufliegt - Fig. 25.

Darauffolgend werden der Verlegefinger 59 und der Stempel 76 gleichzeitig und in fester Zuordnung zueinander sowie zu dem Gehäuse 12 der Anschlußstelle 11 abgesenkt, wobei das zwischen der Druckfläche 78 und der oberen Seite der Berandung der Mündung 74 verlaufende Leitungsstück 84a an zwei Stellen beidseitig der Kontaktierzone abgestützt in den Einführschlitz 19 und den Schneidklemmschlitz 23 eingedrückt wird, bis es die bereits schon anhand von Fig. 18, 19 beschriebene Raststellung erreicht. Die Leitung 68 ist damit an ihrem Leitungsstück 84a einwandfrei kontaktiert und neben der Kontaktstelle beidseitig an ihrer Isolation in dem Führungsschlitz 19 festgeklemmt und fixiert.

Bei der vorliegenden Verdrahtung wird die in der beschriebenen Weise verlegte Leitung bei der Anschlußstelle 11 abgeschnitten. Das geschieht mit dem Messer 79, das nach unten geht und unmittelbar an der mit ihrer Berandung als Gegenmesser wirkenden Mündung 74 des Leitungsführungskanals 62 die Leitung 68 durchschneidet. Die Teile nehmen nunmehr den Zustand nach Fig. 27 ein.

Bei diesem Abschneiden der Leitung 68 wird, wie Fig. 27 zeigt, das in dem Führungsschlitz 19 der Anschlußstelle 11 gehaltene Ende des verlegten Leitungsstücks von der an die Schneide 80 des Messers 79 anschließenden Schrägfläche 86 nach unten zu abgebogen. Das bedeutet, daß die blanke Stirnfläche des Leiters an der Schnittfläche zum Boden der umgebenden nutartigen Vertiefung 26 hin gerichtet wird, mit der Folge, daß die Berührungssicherheit wesentlich erhöht wird. Gleichzeitig ergibt sich durch dieses Abbiegen noch eine zusätzliche mechanische Fixierung des Leitungsendes an der Anschlußstelle 11.

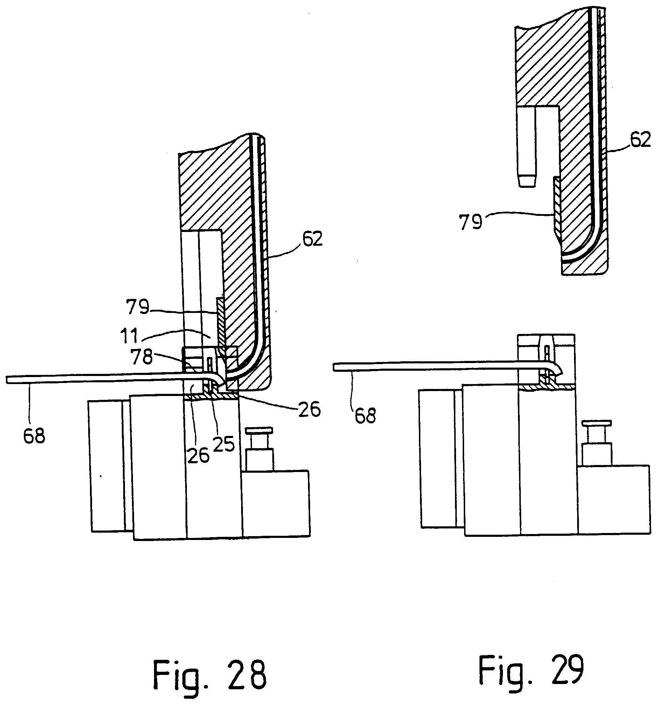

Die Verdrahtung zwischen den beiden Anschlußstellen 10 und 11 ist damit abgeschlossen. Das Messer 79 geht wieder in seine End- oder Ruhestellung entsprechend Fig. 28.

Anschließend werden der Stempel 76 in seine End- oder Ruhestellung zurückgefahren und der Verlegefinger 59 von dem Industrieroboter 33 nach oben gefahren, womit bereits die Ausgangsstellung für den nächsten Verdrahtungsschritt in dem Leuchtenkasten 1 erreicht ist. Diese Ausgangsstellung ist in Fig. 29 dargestellt.

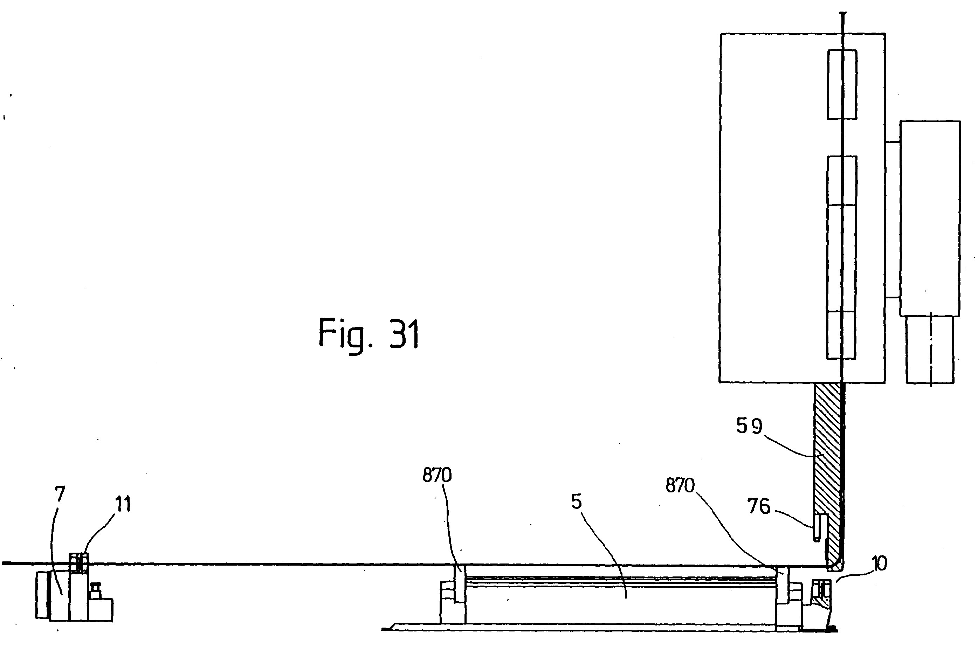

Abhängig von der herzustellenden Verdrahtung kann die Leitung 68 beispielsweise an der Anschlußstelle 11 auch durchverdrahtet werden. In diesem Falle entfällt das Abschneiden der Leitung entsprechend Fig. 27, 28; es wird vielmehr anschließend an den Zustand nach Fig. 26 der Stempel 76 wieder in seine End- oder Ruhestellung zurückgefahren (vgl. Fig. 19, 20), worauf die Steuereinheit programmgemäß veranlaßt, daß der Industrieroboter 33 Leitungsverlegemittel 31 und damit den Verlegefinger 59 auf vorprogrammierter definierter Bahn zu der nächsten Anschlußstelle verfährt. Dies sei kurz anhand der Fig. 31 bis 33 veranschaulicht:

Die nächstfolgende Anschlußstelle ist wiederum eine Anschlußstelle 10, aber nunmehr des rechten Vorschaltgeräts 5 in Fig. 1. Dabei muß die Leitung über das Vorschaltgerät 5 hinweggeführt werden. Das Vorschaltgerät 5 ist, wie insbesondere aus Fig. 2 zu entnehmen, im Bereiche seiner beiden Enden oben mit zwei Halterungselementen 870 für Leitungen 68 ausgerüstet. Jedes der kammartigen Halterungselemente 870 ist mit einer Reihe von parallelen durchgehenden Rastnuten 88 halbkreisförmiger Querschnittsgestalt versehen, in die jeweils eine Leitung 68 über einen Einführschlitz 89 eingedrückt werden kann.

Bei der Leitungsverlegung zwischen den Anschlußstellen 11, 10 (Fig. 26 und 31) bringt deshalb der Industrieroboter 33 auf vorprogrammierter Bahn den Verlegefinger 59 zunächst in die Nähe des jeweiligen Halterungselementes 870. Nach erfolgter Positionierung des Verlegefingers 59 in bereits beschriebener Weise mittels des Bildverarbeitungssystems 85 geht der Stempel 76 nach unten und drückt entweder allein oder gemeinsam mit dem Verlegefinger 59 die Leitung in eine der Rastnuten 88. Anschließend wird der Stempel 76 wieder in seine End- oder Ruhestellung gebracht; der Verlegefinger 59 fährt nach oben und wird zu dem nächstfolgenden Halterungselement 870 verfahren, wo sich der gleiche Vorgang wiederholt.

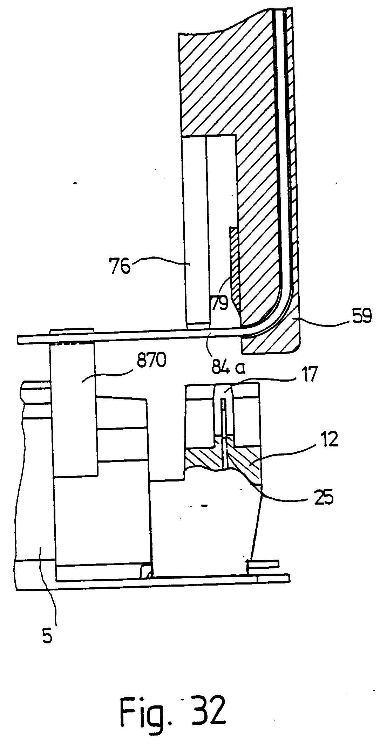

Darauffolgend wird der Verlegefinger 59 in die Nähe der Anschlußstelle 10 gebracht und in bereits erläuterter Weise über dieser positioniert, worauf der Stempel 76 wieder vorgefahren wird, bis seine Druckfläche 78 auf dem aus der Mündung 74 austretenden Leitungsstück 84a aufliegt. Die Teile nehmen den Zustand nach Fig. 32 ein.

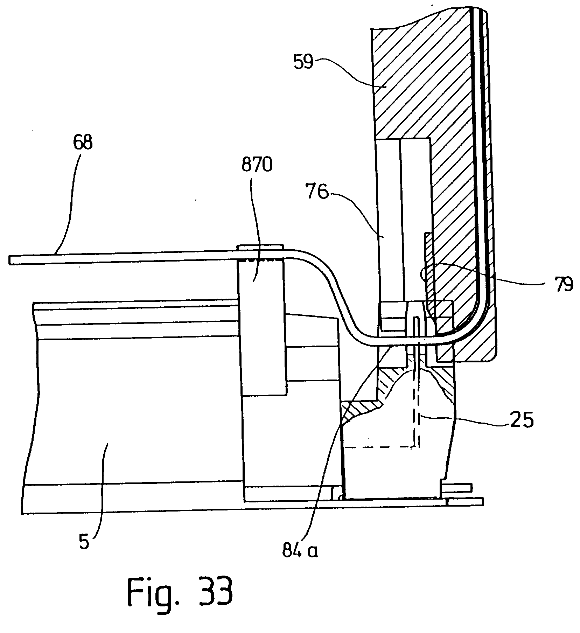

Bei der sich nun anschließenden Absenkbewegung des Verlegefingers 49 des Stempels 76 wird nicht nur das Leitungsstück 84a horizontal ausgerichtet und einwandfrei abgestützt in bereits beschriebener Weise in dem Einführschlitz 19 fixiert und in dem Schneidklemmschlitz 23 kontaktiert, sondern es wird gleichzeitig die Leitung 68 auch auf das Niveau des Schneidklemmkontaktes 25 herabgebogen. Nach abgeschlossener Kontaktierung nehmen die Teile die Stellung nach Fig. 33 ein.

Als nächster Schritt kann nunmehr die Leitung 68 entweder abgeschnitten werden (entsprechend Fig. 27) oder aber, sie wird zu der nächstfolgenden Anschlußstelle, beispielsweise einer Anschlußstelle 9 eines Lampensockels 4 durchverdrahtet.

Da bei dem Lampensockel 4 die Einführschlitze 19 an den Anschlußstellen 9 quer zur Leuchtenkastenlängsrichtung ausgerichtet sind, muß der Industrieroboter 33 die Leitungsverlegemittel 31 und,hier insbesondere das Gehäuse 58 des Verlegewerkzeugs 57 mit dem Verlegefinger 59 und dem Stempel 76, um 90^{o} um die Vertikalachse (c-Achse) drehen, bevor das dabei abgebogene Leitungsteil in den Einführungsschlitz 19 in bereits beschriebener Weise eingeführt wird.

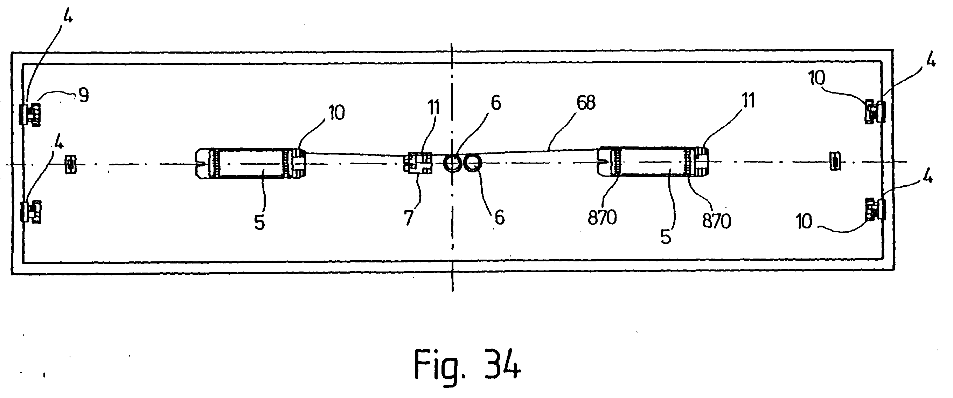

Die mittels der beschriebenen Verfahrensschritte ausgeführte Direktverdrahtung des vormontierten Leuchtenkastens 1 ist in den Fig 33, 34 für die beiden Fälle veranschaulicht, daß einmal die Leitung 68 nach Erreichen der Anschlußstelle 11 abgeschnitten wird (Fig. 27) bzw. daß sie über diese Anschlußstelle hinaus durchverdrahtet wird (Fig. 31).

## Patentansprüche

1. Verfahren zum Verdrahten von Anschlußstellen elektrischer Geräte oder Baugruppenelemente mit Hilfe von gesteuerten mechanischen Leitungsverlegemitteln (31), bei dem folgende Schritte ausgeführt werden:
- ein vormontiertes elektrisches Gerät (1) oder Baugruppenelement wird mit fest darin angeordneten Anschlußstellen (9,10,11) bereitgestellt, die Kontaktierzonen (23,24,25) in Schneidklemmtechnik aufweisen.
- durch eine Relativbewegung zwischen dem vormontierten Gerät (1) oder Baugruppenelement und den Leitungsverlegemitteln (31) wird eine erste Anschlußstelle in den Arbeitsbereich der Leitungsverlegemittel gebracht und relativ zu diesen lagerichtig positioniert,
- mittels der Leitungsverlegemittel (31) wird das Ende einer diesen endlos zugeführten Leitung (68) in eine Kontaktierzone der ersten Anschlußstelle eingeführt und dabei unter Herstellung eines elektrischen Kontaktes in deren Schneidklemme (25) eingedrückt und an dieser Anschlußstelle fixiert,
- durch jeweils eine weitere Relativbewegung längs einer vorgegebenen Bahn zwischen dem vormontierten elektrischen Gerät (1) oder Baugruppenelement und den Leitungsverlegemitteln (31) wird unter Verlegung der Leitung aufeinanderfolgend jede weitere Anschlußstelle in den Arbeitsbereich der Leitungsverlegemittel gebracht und relativ zu diesen lagerichtig positioniert, wobei während jeder dieser Relativbewegungen die Leitungsverlegemittel zumindest eine dem Leitungsverlegeweg zwischen den beiden jeweiligen Anschlußstellen entsprechende Länge der ihnen endlos zugeführten Leitung (68) ausgegeben wird, die so groß bemessen wird, daß die zwischen den Anschlußstellen verlegte Leitung im wesentlichen zugspannungsfrei ist,
- mittels der Leitungsverlegemittel (31) wird die diesen endlos zugeführte Leitung (68) bei jeder Anschlußstelle in die betreffende Kontaktierzone dieser Anschlußstelle eingeführt und dabei unter Herstellung eines elektrischen Kontaktes in die Schneidklemme (25) eingedrückt und fixiert,
- die so verlegte Leitung (68) wird sodann am Ende des Leitungsverlegeweges im Bereiche der diesem entsprechenden Anschlußstelle (12) nach dem Kontaktieren und Fixieren neben der Kontaktierzone abgeschnitten, wobei das Leitungsende an der Schneidklemme (25) zugleich berührungssicher verwahrt wird.

2. Verfahren nach Anspruch 1, dadurch gekennzeichnet, daß durch eine Relativbewegung zwischen dem vormontierten elektrischen Gerät (1) oder Baugruppenelement eine Abstütz- oder Halterungsstelle in den Arbeitsbereich der Leitungsverlegemittel gebracht und relativ zu dieser lagerichtig positioniert wird und daß mittels der Leitungsverlegemittel (31) die Leitung in eine Halterung (870) an der Abstütz- oder Halterungsstelle eingebracht und dort betestigt wird.

3. Verfahren nach Anspruch 1 oder 2, dadurch gekennzeichnet, daß die Leitungsverlegemittel (31) von einem mehrachsig beweglichen programmierbaren Handhabungsgerät oder Industrieroboter (33) bewegt werden und daß das vormontierte elektrische Gerät (1) oder Baugruppenelement vor Beginn der Verdrahtung in einer Ausgangsposition angeordnet wird.

4. Verfahren nach Anspruch 1 oder 2, dadurch gekennzeichnet, daß die Leitungsverlegemittel (31) ortsfest oder an einer ihnen lediglich eine Positionierbewegung erteilenden Positioniereinrichtung (56) angeordnet sind und daß das vormontierte elektrische Gerät (1) oder Baugruppenelement mittels eines relativ zu den Leitungsverlegemitteln (31) verfahrbaren Transportmittels (54) bewegt wird.

5. Verfahren nach einem der vorhergehenden Ansprüche, dadurch gekennzeichnet, daß die während einer Leitungsverlegung zwischen zwei Anschlußstellen von den Leitungsverlegemitteln (31) abgegebene Leitungslänge mit der Relativbewegung zwischen dem vormontierten elektrischen Gerät (1) oder Baugruppenelement und den Leitungsverlegemitteln (31) zwangssynchronisier wird.

6. Verfahren nach einem der vorhergehenden Ansprüche, dadurch gekennzeichnet, daß mit der Relativbewegung zwischen dem vormontierten elektrischen Gerät (1) oder Baugruppenelement und den Leitungsverlegemitteln (31) die Leitungsverlegemittel in die Nähe der jeweiligen Anschlußstelle (9,10,11) gesteuert werden und anschließend in einer Positionierbewegung genau lagerichtig zu der Anschlußstelle positioniert werden.

7. Verfahren nach Anspruch 6, dadurch gekennzeichnet, daß bei in die Nähe der Anschlußstelle gebrachten Leitungsverlegemittel (31) mit Hilfe von Lagefühlmitteln (85) die Lageabweichung von der Position der Anschlußstelle ermittelt und selbsttätig ausgeglichen wird.

8. Verfahren nach Anspruch 7, dadurch gekennzeichnet, daß zur Ermittlung der Lageabweichung ein den Leitungsverlegemitteln zugeordnetes Bildverarbeitungssystem (85) verwendet wird, welches zur Bildaufnahme nahe zu der Anschlußstelle gebracht wird und das Einrichtungen zur Bildauswertung aufweist, in denen der Ausgleich der Lageabweichung berechnet und ein entsprechendes Steuersignal abgegeben wird.

9. Verfahren nach einem der vorhergehenden Ansprüche dadurch gekennzeichnet, daß nach dem Positionieren der Leitungsverlegemittel (31) der Leitung (68) im Bereiche der Anschlußstelle eine Einführbewegung definierter Weglänge erteilt wird, mit der sie in die Schneidklemme (25) eingedrückt wird.

10. Verfahren nach einem der vorhergehenden Ansprüche, dadurch gekennzeichnet, daß die Relativbewegung zwischen dem vormontierten elektrischen Gerät (1) oder Baugruppenelement und den Leitungsverlegemitteln (31) zumindest abschnittsweise im wesentlichen geradlinig ist.

11. Verfahren nach Anspruch 1, dadurch gekennzeichnet, daß die Leitung (68) beim Eindrücken beidseitig der Kontaktierzone mit einer Eindrückkraft belastet wird.

12. Verfahren nach Anspruch 11, dadurch gekennzeichnet, daß die Leitung (68) auf wenigstens einer Seite der Kontaktierzone festgeklemmt wird.

13. Verfahren nach einem der vorhergehenden Ansprüche, dadurch gekennzeichnet, daß die Leitung (68) unmittelbar an den Leitungsverlegemitteln (31) abgeschnitten wird.

14. Verfahren nach einem der Ansprüche 10 bis 12, dadurch gekennzeichnet, daß die Leitung (68) an der Schneidklemme (25) abgeschnitten wird.

15. Verfahren nach einem der Ansprüche 10 bis 13, dadurch gekennzeichnet, daß die Leitung (68) in der Kontaktierzone zwischen Schneidklemmen (25) abgeschnitten wird.

16. Verfahren nach einem der vorhergehenden Ansprüche, dadurch gekennzeichnet, daß das Leitungsende an der Schneidklemme in einer an dieser vorhandenen offenen nut- oder schlitzartigen Vertiefung (26) verwahrt wird.

17. Verfahren nach einem der vorhergehenden Ansprüche, dadurch gekennzeichnet, daß es zur automatischen Verdrahtung von Leuchten oder deren Teile verwendet wird.

18. Leitungsverlegemittel zur Durchführung des Verfahrens nach einem der vorhergehenden Ansprüche, mit einem Verlegewerkzeug (57), das ein mit Befestigungsmitteln versehenes Gehäuse (58), einen auf einer Antriebsseite des Gehäuses in einem Verlegefinger (59) mündenden Führungskanal (62) für eine Leitung (68), gesteuerte Vorschubmittel (66, 67) für die Leitung und ein in der Nähe der Mündung des Führungskanals angeordnetes, verstellbar gelagertes Druckglied (76) für die aus der Mündung austretende Leitung sowie ein Abschneidemesser(79) aufweist, wobei das Druckglied (76) quer zu der Achsrichtung des Führungskanals (62) im Mündungsbereich beweglich gelagert und mit einer eigenen Stellvorrichtung gekuppelt ist, durch die es aus einer von der Mündung (74) entfernten Ruhestellung in eine Arbeitsstellung verstellbar ist, dadurch gekennzeichnet, daß der Verlegefinger (59) eine Bodenfläche (61) aufweist, eine Seitenwand (60) aufweist, in der die Mündung (74) des Führungskanals (62) liegt und auf der das Abschneidemesser (79) beweglich geführt ist, daß die Unterseite (81) der Mündungsberandung des Führungskanals (62) als Gegenmesser dient und das Druckglied (76) in seiner Arbeitsstellung mit einer auf die aus der Mündung (74) vorragende Leitung (84) ausgerichteten Druckfläche (78) den Rand des Führungskanals (62) einseitig überragt oder mit der Oberseite des Randes im wesentlichen fluchtet und daß der Verlegefinger (59) an seinem Ende zum Zusammenwirken mit zugeordneten Führungsmitteln (26) an der Anschlußstelle eingerichtet ist.

19. Leitungsverlegemittel nach Anspruch 18, dadurch gekennzeichnet, daß das Druckglied ein an dem Gehäuse (58) oder einem mit diesem verbundenen Teil längsverschieblich geführter Stempel (76) ist.

20. Leitungsverlegemittel nach Anspruch 19, dadurch gekennzeichnet, daß der Stempel (76) parallel zu dem ebenfalls als Stempel ausgebildeten Verlegefinger (59) im Abstand zu diesem angeordnet ist.

21. Leitungsverlegemittel nach einem der Ansprüche 18 bis 20, dadurch gekennzeichnet, daß das Druckglied (76) und der Verlegefinger (59) quer zu der Längsrichtung der aus der Mündung (74) des Führungskanals (62) austretenden Leitung gemessen, zumindest bereichsweise etwa gleiche Breite aufweisen.

22. Leitungsverlegemittel nach einem der Ansprüche 18 bis 21, dadurch gekennzeichnet, daß der Verlegefinger (59) an dem Gehäuse (57) beweglich gelagert und mit einer eigenen Stellvorrichtung gekuppelt ist.

23. Anschlußstelle, insbesondere zur Verwendung bei dem Verfahren nach einem der Ansprüche 1 bis 17 unter Benutzung der Leitungsverlegemittel (31) nach einem der Ansprüche 18 bis 22, mit eine Kontaktzone enthaltenden Anschlußklemmen, die jeweils ein Gehäuse (12, 12a) aus Isoliermaterial mit wenigstens einem randoffenen Einführschlitz (19) für eine Leitung (68) und zumindest einem in dem Gehäuse angeordneten Schneidklemmkontakt (25) mit einem auf den Einführschlitz (19) ausgerichteten, zur Einführseite hin randoffenen Schneidklemmschlitz (23) aufweisen, dadurch gekennzeichnet, daß das Gehäuse (12, 12a) jeder der Anschlußklemmen mit einem für die Leitungsverlegemittel (31) zugänglichen Einführschlitz (19) angeordnet ist, daß das Gehäuse (12, 12a) auf zumindest einer Seite anschließend an den Einführschlitz (19) eine die Leitung aufnehmende, offene, schlitz- oder nutartige Vertiefung (26) aufweist, deren Weite größer als die Breite des Einführschlitzes (19) ist, daß die schlitz- oder nutartige Vertiefung (26) als Berührungsschutz für eine in der Nähe des Schneidklemmkontaktes (25) befindliches, in der Vertiefung (26) aufgenommenes freies Ende einer in dem Schneidklemmkontakt (25) kontaktierten Leitung ausgebildet ist und daß die Vertiefung (26) als Führungsmittel für den Verlegefinger (59) und/oder das Druckglied (76) eines Verlegewerkzeuges von Leitungsverlegemitteln (31) geeignet ist.

24. Anschlußstelle nach Anspruch 23, dadurch gekennzeichnet, daß der Einführschlitz (19) eine eine Klemmfixierung der eingedrückten Leitung bewirkende Breite aufweist.

25. Anschlußstelle nach Anspruch 23 oder 24, dadurch gekennzeichnet, daß die Vertiefung (26) in dem Gehäuse (12) beidseitig von Schneidklemmkontakten (25) begrenzt ist.

26. Anschlußstelle nach einem der Ansprüche 23 bis 25 dadurch gekennzeichnet, daß die Vertiefung (26) tiefer als der Einführschlitz (19) ist.

## Claims

1. A method for wiring terminals of electrical devices or module elements with the aid of controlled mechanical line-laying means (31), in which the following steps are performed:
- a preassembled electrical device (1) or module element is provided with fixedly disposed terminals (9, 20, 11) which have contacting zones (23, 24, 25) designed in accordance with IDC technique;
- a first terminal is brought by a relative movement between the preassembled device (1) or module element and the line-laying means (31) into the operating range of the line-laying means and positioned correctly relative to this;
- the end of a line (68) supplied endlessly thereto is fed into a contacting zone of the first terminal by means of the line-laying means (31) and pressed into its IDC contact (25), thereby producing an electrical contact, and is fixed to this terminal;
- respectively by a further relative movement along a predetermined path between the preassembled electrical device (1) or module element and the line-laying means (31), each other terminal is brought consecutively into the operating range of the line-laying means, thereby laying the line, and positioned correctly relative to these devices, whereby, during each of these relative movements, a length of line (68) endlessly supplied to the line-laying means at least corresponding to the line laying course between the two respective terminals is supplied by the line-laying means, said line being dimensioned so that the line laid between the terminals is substantially free of tensile strain;
- the line (68) endlessly supplied to the line-laying means (31) is introduced at each terminal by these means into the respective contacting zone of the respective terminal and pressed and fixed into the IDC contact (25), thereby producing an electrical contact;
- the line (68) thus laid is then cut off next to the contacting zone at the end of the line laying course in the region of the terminal (11) corresponding thereto after contacting and fixing, whereby the end of the line is simultaneously protected against contact at the IDC contact (25).

2. Method according to Claim 1, characterised in that by means of a relative movement between the preassembled electrical device (1) or module element, a support or retention element is brought into the operating range of the line-laying means and positioned correctly relative thereto; and that the line is introduced into a line mount (870) at the support or retention element by means of the line-laying means (31) and secured there.

3. Method according to Claim 1 or 2, characterised in that the line-laying means (31) are moved by a multiaxially movable, programmable manipulator or industrial robot (33); and that the preassembled electrical device (1) or module element is arranged in a starting position prior to the beginning of wiring.

4. Method according to Claim 1 or 2, characterised in that the line-laying means (31) are stationary or are located at a positioning device (56) imparting a positioning movement to them; and that the preassembled electrical device (1) or module element is moved by means of a transport means (54) which is movable relative to the line-laying means (31).

5. Method according to one of the preceding claims, characterised in that the line length supplied during line-laying between two terminals by the line-laying means (31) is forcibly synchronised with the relative movement between the preassembled electrical device (1) or module element and the line-laying means (31).

6. Method according to one of the preceding claims, characterised in that with the relative movement between the preassembled electrical device (1) or module element and the line-laying means (31), the line-laying means are controlled in the vicinity of the respective terminal (7, 10, 11) and are subsequently positioned in a positioning movement in precise position relative to the terminal.

7. Method according to Claim 6, characterised in that the positional deviation of the line-laying means (31) from the position of the terminal is ascertained with the aid of position sensing means (85), once the line-laying means have been brought into the vicinity of the terminal, and automatically compensated.

8. Method according to Claim 7, characterised in that in order to ascertain the positional deviation, an image processing system (85) assigned to the line-laying means is used which is moved close to the terminal for taking an image and has systems for image evaluation in which the compensation of the positional deviation is calculated and a corresponding control signal is emitted.

9. Method according to one of the preceding claims, characterised in that after positioning the line-laying means (31), an introduction motion of defined course length is imparted to the line (68) in the region of the terminal, with which motion the line is brought into the IDC contact (25).

10. Method according to one of the preceding claims, characterised in that the relative movement between the preassembled electrical device (1) or module element and the line-laying means (31) is, at least intermittently, substantially rectilinear.

11. Method according to Claim 1, characterised in that upon being pressed into the contacting zone, the line (68) is subjected to a pressing-in force on both sides.

12. Method according to Claim 11, characterised in that the line (68) is firmly clamped on at least one side of the contacting zone.

13. Method according to one of the preceding claims, characterised in that the line (68) is cut off directly at the line-laying means (31).

14. Method according to one of Claims 10 to 12, characterised in that the line (68) is cut at the IDC contact (25).

15. Method according to one of Claims 10 to 13, characterised in that the line (68) is cut between IDC contacts (25) in the contacting zone.

16. Method according to one of the preceding claims, characterised in that the end of the line is protected at the IDC contact in an open groove- or slot-like indentation (26) provided therein.

17. Method according to one of the preceding claims, characterised in that it is used for the automatic wiring of lights or their parts.

18. Line-laying means for carrying out the method according to one of the preceding claims, comprising a line-laying tool (57), which has a housing (58) fitted with fastening elements, a guide conduit (62) for a line (68) on a working side of the housing terminating in a laying prong (59), controlled feed means (66, 67) for the line and an adjustably supported pressure member (76) located in the vicinity of the mouth of the guide conduit for the line emerging from the mouth, and also a cutting means (79), said pressure member (76) being movably supported for movement transversely to the axial direction of the guide conduit (62) in the mouth region and being coupled to its own positioning means, by means of which it may be moved out of a position of repose remote from the mouth (74) into an operating position, characterised in that the laying prong (59) has a bottom face (61) and has a side wall (60), in which the mouth (74) of the guide conduit (62) lies and on which the cutting means (79) is movably guided; that the bottom side (81) of the edge of the mouth (74) of the guide conduit (62) forms a counterelement for cutting and the pressure member (76) in its operating position protrudes on one side past the edge of the guide conduit (62) with a pressure face (78) aligned with the line (84) protruding from the mouth (74) or is substantially flush with the top of the edge; and that the laying prong (59) is arranged at its end at the terminal for cooperation with assigned guide means (26).

19. Line-laying means according to Claim 18, characterised in that the pressure member is a ram (76) which is guided to be longitudinally displaceable on the housing (58) or a part connected thereto.

20. Line-laying means according to Claim 19, characterised in that the ram (76) is located parallel to the laying prong (59), which is likewise constructed as a ram, and at a distance therefrom.

21. Line-laying means according to one of Claims 18 to 20, characterised in that the pressure member (76) and the laying prong (59), at least in part, essentially have the same width, measured transversely to the longitudinal direction of the line emerging from the mouth (74) of the guide conduit (62).

22. Line-laying means according to one of Claims 18 to 21, characterised in that the laying prong (59) is movably mounted on the housing (57) and is coupled to its own positioning means.

23. Terminal, in particular for use in the method according to one of Claims 1 to 17 while using the line-laying means (31) according to one of Claims 18 to 22, with connecting terminals containing a contacting zone, respectively having a housing (12, 12a) made of insulating material with at least one introduction slit (19) open at the edge for a line (68) and at least one IDC contact (25) arranged in the housing with an IDC slit (23) aligned on the introduction slit (19) open at the edge towards the side of introduction, characterised in that the housing (12, 12a) of each of the connecting terminals is provided with an introduction slit (19) accessible for the line-laying means (31); that the housing (12, 12a), on at least one side adjoining the introduction slit (19), has an open slot- or groove-like indentation (26) receiving the line, the width of said indentation being larger than the width of the introduction slit (19); that the slot- or groove-like indentation (26) is provided as contact protection for a free end of a line contacting in the IDC contact (25) which is located in the vicinity of the IDC contact (25) and received in the indentation (26); and that the indentation (26) is suitable as a guide means for the laying prong (59) and/or the pressure member (76) of a laying tool of line-laying means (31).

24. Terminal according to Claim 23, characterised in that the introduction slit (19) has a width effecting a clamping fixture of the pressed-in line.

25. Terminal according to Claim 23 or 24, characterised in that the indentation (26) is defined in the housing (12) on both sides of the IDC contacts (25).

26. Terminal according to one of Claims 23 to 25, characterised in that the indentation (26) is deeper than the introduction slit (19).

## Revendications

1. Procédé de câblage des points de couplage d'appareils ou de sous-ensembles électriques à l'aide de moyens (31) mécaniques de câblage, comprenant les étapes suivantes:
- on prend un appareil électrique (1) ou un sous-ensemble préassemblé avec des points de couplage (9, 10, 11) fixes qui comportent des zones de connexion (23, 24, 25) de type autodénudantes.
- par un déplacement relatif entre l'appareil (1) électrique ou le sous-ensemble préassemblé et les moyens (31) de câblage, on amène un premier point de couplage dans la zone de travail des moyens de câblage et on le positionne correctement par rapport à ceux-ci.
- à l'aide des moyens (31) de câblage, on introduit l'extrémité d'un conducteur (68) délivré en continu dans une zone de connexion du premier point de couplage, on la presse dans la borne (25) autodénudante de celle-ci en réalisant un contact électrique et on la fixe audit point de couplage.
- par, chaque fois, un déplacement relatif supplémentaire suivant une trajectoire prédéterminée entre l'appareil (1) électrique ou le sous-ensemble préassemblé et le moyen (31) de câblage, au cours duquel le conducteur est mis en place, on amène successivement chacun des autres points de couplage dans la zone travail des moyens de câblage et on les positionne correctement par rapport à celui-ci, les moyens de câblage délivrant, au cours de chacun de ces déplacements, au moins une longueur de fil (68) continu qui correspond à la longueur du trajet de déplacement entre les deux points de couplage et qui est telle que le conducteur posé entre les points de couplage soit sensiblement exempt de contraintes de traction.
- à l'aide des moyens (31) de câblage on introduit le conducteur (68) délivré en continu, au niveau de chaque point de couplage, dans la zone de connexion concernée du point de couplage et le presse dans la borne (25) autodénudante pour réaliser un contact électrique et on le fixe.
- à la fin du trajet de câblage, dans la région du point de couplage (11) correspondant, on coupe le conducteur (68) ainsi posé après sa connexion et sa fixation, à proximité de la zone de connexion, l'extrémité du conducteur dans la borne autodénudante étant simultanément protégée contre les contacts.

2. Procédé selon la revendication 1, caractérisé par le fait que par un déplacement de l'appareil (1) électrique ou du sous-ensemble préassemblé, on amène un point de support ou de fixation dans la zone de travail des moyens de câblage et on le positionne correctement par rapport à ceux-ci et par le fait qu'à l'aide des moyens (31) de câblage on place le conducteur dans un support (870) du point de support ou de fixation et on l'y fixe.

3. Procédé selon la revendication 1 ou 2, caractérisé par le fait que les moyens (31) de câblage sont déplacés par un manipulateur ou un robot industriel (35) programmable, mobile suivant plusieurs axes, et par le fait que l'appareil (1) électrique ou le sous-ensemble préassemblé, au début du câblage, est disposé dans une position de départ.

4. Procédé selon la revendication 1 ou 2, caractérisé par le fait que les moyens (31) de câblage sont fixes ou sont disposés sur un dispositif (56) de positionnement qui applique auxdits moyens de câblage exclusivement un mouvement de positionnement et par le fait que l'appareil (1) électrique ou le sous-ensemble préassemblé sont déplacés à l'aide de moyens de transport (54) mobiles par rapport aux moyens (31) de câblage.

5. Procédé selon l'une des revendications précédentes, caractérisé par le fait que la longueur de conducteur délivrée par les moyens (31) de câblage entre deux points de couplage, au cours d'une opération de câblage, est asservie au déplacement relatif entre l'appareil (1) électrique ou le sous-ensemble préassemblé et les moyens (31) de câblage.

6. Procédé selon l'une des revendications précédentes, caractérisé par le fait que par déplacement relatif entre l'appareil (1) électrique ou le sous-ensemble assemblé et les moyens (31) de câblage, on amène les moyens de câblage dans le voisinage du point de couplage (9, 10, 11) concerné, puis par un déplacement de positionnement on les positionne avec précision par rapport au point de couplage.

7. Procédé selon la revendication 6, caractérisé par le fait que lorsque les moyens (31) de câblage ont été amenés dans le voisinage du point de couplage, on détermine à l'aide de détecteurs de position (85) l'écart de position par rapport au point de couplage et on le compense de manière automatique.

8. Procédé selon la revendication 7, caractérisé par le fait que l'on utilise, pour déterminer l'écart de position, un système (85) d'exploitation d'images associé aux moyens de câblage, qui, à des fins de prise de vues, est amené dans la région du point de couplage et qui comporte des moyens d'exploitation d'image, dans lesquels la compensation de l'écart de position est calculée et un signal de commande adapté est émis.

9. Procédé selon l'une des revendications précédentes, caractérisé par le fait qu'après avoir positionné les moyens (31) de câblage, on imprime au conducteur (68), dans la région du point de couplage, un mouvement d'insertion, avec une longueur de course définie, par lequel le conducteur est pressé dans la borne (25) autodénudante.

10. Procédé selon l'une des revendications précédentes, caractérisé par le fait que le déplacement relatif entre l'appareil (1) électrique ou le sous-ensemble préassemblé et les moyens (31) de câblage est, au moins localement, sensiblement rectiligne .

11. Procédé selon la revendication 1, caractérisé par le fait que lors de l'insertion du conducteur dans la borne, on applique sur le conducteur (68) une force d'insertion de part et d'autre de la zone de connexion.

12. Procédé selon la revendication 11, caractérisé par le fait que l'on bride le conducteur (68), d'un côté au moins de la zone de connexion.

13. Procédé selon l'une des revendications précédentes, caractérisé par le fait que l'on coupe le conducteur (68) directement au niveau des moyens (31) de câblage.

14. Procédé selon l'une des revendications 10 à 12, caractérisé par le fait que l'on coupe le conducteur (68) au niveau de la borne (25) autodénudante.

15. Procédé selon l'une des revendications 10 à 13, caractérisé par le fait que l'on coupe le conducteur (68) dans la zone de connexion entre des bornes (25) autodénudantes.

16. Procédé selon l'une des revendications précédentes, caractérisé par le fait que l'on place l'extrémité du conducteur, au niveau de la borne de connexion, dans une cavité (26) ouverte, en forme de rainure ou de fente, de celle-ci.

17. Procédé selon l'une des revendications précédentes, caractérisé par le fait qu'il est utilisé pour le câblage automatique d'appareils d'éclairage ou d'éléments de ceux-ci.

18. Moyens de câblage pour la mise en oeuvre du procédé selon l'une des revendications précédentes, avec un outil (57) de câblage qui comporte un boîtier (58) pourvu de moyens de fixation, un canal de guidage (62) pour un conducteur (68) qui débouche dans un doigt (59) de câblage placé sur un côté du boîtier, des moyens (66, 67) commandés d'avance du conducteur, un pied presseur (76) pour le conducteur sortant de l'embouchure, qui est monté avec possibilité de réglage dans la région de l'embouchure du canal de guidage, ainsi qu'un couteau (79), le pied presseur (76) étant monté mobile transversalement à l'axe du canal de guidage (62), dans la région de l'embouchure, et étant couplé à un dispositif de commande spécifique, par lequel il est amené d'une position de repos, éloignée de l'embouchure (74), dans une position de travail, caractérisés par le fait que le doigt de câblage (59) comporte un fond (61), une paroi latérale (60) dans laquelle est située l'embouchure (74) du canal de guidage (62) et sur laquelle le couteau (79) est guidé avec possibilité déplacement, par le fait que le côté inférieur (81) du bord de l'embouchure du canal de guidage (62) est agencé en contre-lame et que l'élément-presseur (76), dans sa position de travail, par une surface de pression (78) tournée vers le conducteur (84) sortant de l'embouchure (74), dépasse d'un côté le bord du canal de guidage (62) ou est sensiblement aligné avec le côté supérieur du bord et par le fait que le doigt de câblage (59), est agencé, au niveau de son extrémité, de manière à coopérer avec des moyens de guidage (26) du point de couplage.

19. Moyens de câblage selon la revendication 18, caractérisés par le fait que le pied presseur est un piston (76) qui est monté coulissant dans la direction longitudinale sur le boîtier (58) ou sur un élément lié à celui-ci.

20. Moyens de câblage selon la revendication 19, caractérisés par le fait que le piston (76) est disposé parallèlement au doigt de câblage (59), à distance de celui-ci, lequel doit de câblage est également conformé en piston.

21. Moyens de câblage selon l'une des revendications 18 à 20, caractérisés par le fait que le pied presseur (76) et le doigt de câblage (59) ont au moins localement sensiblement la même largeur, mesurée transversalement à la direction longitudinale du conducteur sortant de l'embouchure (74) du canal de guidage (62).

22. Moyens de câblage selon l'une des revendications 18 à 21, caractérisés par le fait que le doigt de câblage (59) est monté mobile sur le boîtier (57) et est couplé à un dispositif spécifique de commande.

23. Point de couplage, destiné notamment à être utilisé avec le procédé selon les revendications 1 à 17, en liaison avec les moyens (31) de câblage selon l'une des revendications 18 à 22, avec une zone de connexion comportant des bornes de connexion qui présentent chacune un boîtier (12, 12a) en un matériau isolant, avec au moins une fente d'introduction (19) pour un conducteur (68) ouverte d'un côté et au moins une borne de connexion (25) autodénudante pourvue d'une fente (23) d'incision et de serrage ouverte d'un côté, en direction du bord et tournée vers la fente d'introduction (19), caractérisé par le fait que le boîtier (12, 12a) de chaque borne de connexion est pourvu d'une fente (19) d'introduction accessible aux moyens de câblage (31), par le fait que le boîtier (12, 12a), sur au moins un côté consécutif à la fente d'introduction (19) comporte une cavité (26) ouverte en forme de fente ou de rainure qui reçoit le conducteur, dont la largeur est supérieure à la largeur de la fente d'introduction (19), par le fait que la cavité (26) en forme de fente ou de rainure est configurée en moyen de protection contre les contacts pour une extrémité libre située dans le voisinage de la borne (25) autodénudante et placée dans la cavité (26), d'un conducteur connecté à la borne (25) autodénudante et par le fait que la cavité (26) sert de moyen de guidage pour le doigt de câblage (59) et/ou pour le pied presseur (76) d'un outil de câblage des moyens (31) de câblage.

24. Point de couplage selon la revendication 23, caractérisé par le fait que la fente d'introduction (19) a une largeur qui assure un blocage par serrage du conducteur pressé dans celle-ci.

25. Point de couplage selon la revendication 23 ou 24, caractérisé par le fait que la cavité (26) dans le boîtier (12) est délimité des deux côtés par des bornes (25) autodénudantes.

26. Point de couplage selon l'une des revendications 23 à 25, caractérisé par le fait que la cavité (26) a une profondeur supérieure à la fente d'introduction (19).
